# EUROPEAN PATENT APPLICATION

(11) **EP 4 821 681 A1**
(43) Date of publication of application: **14.10.2026**
(21) Application number: 25844443.9
(22) Date of filing: 30.06.2025
(51) Int. Cl.: B32B 27/32, B29C 65/02, B32B 9/00, B32B 27/34, B65D 65/40, C23C 14/08

(54) **BARRIER FILM, LAMINATE, AND PACKAGING BAG**

(30) Priority: 23.07.2024 JP 2024118254; 31.01.2025 JP 2025015282
(71) Applicant: Dai Nippon Printing Co., Ltd., Tokyo 162-8001 (JP)
(72) Inventor: SUZUKI Tsuyoshi, Tokyo 162-8001 (JP); NISHIDA Tomoyuki, Tokyo 162-8001 (JP); MIYAZAKI Yusuke, Tokyo 162-8001 (JP); IWASAKI Yuya, Tokyo 162-8001 (JP); TAMADA Shuhei, Tokyo 162-8001 (JP); MORIMOTO Taro, Tokyo 162-8001 (JP); OIKAWA Wataru, Tokyo 162-8001 (JP); KOICHI Chisayo, Tokyo 162-8001 (JP); ONODA Junna, Tokyo 162-8001 (JP); YUNO Masato, Tokyo 162-8001 (JP); MATSUI Shigeki, Tokyo 162-8001 (JP)
(74) Representative: Müller-Boré & Partner Patentanwälte PartG mbB
(86) International application number: PCT/JP2025/023539
(87) International publication number: WO 2026/023348

(57) **Abstract**

The barrier film of the present disclosure includes a vapor deposition film 15 on a side of a first resin layer 11 of a polymer film 10, wherein the polymer film 10 includes the first resin layer 11, a second resin layer 12, and a third resin layer 13 in this order, the first resin layer 11 constitutes one outermost layer of the polymer film 10, the first resin layer 11 contains an aromatic polyamide as a polyamide resin, the ratio of the number of diamine units contained in the aromatic polyamide to the total number of aminocarboxylic acid units and diamine units contained in the polyamide resin constituting the first resin layer 11 is 85 mol% or more, the ratio of the number of aromatic diamine units contained in the aromatic polyamide to the total number of aminocarboxylic acid units and diamine units contained in the polyamide resin constituting the first resin layer 11 is 15 mol% or more and 70 mol% or less, the content of an amorphous aromatic polyamide in the first resin layer 11 is 25 mass% or more, the second resin layer 12 includes an acid-modified product of polypropylene, the third resin layer 13 includes homopolypropylene, and the vapor deposition film 15 includes an inorganic oxide.

## Description

### Technical Field

The present disclosure relates to a barrier film, a laminate, and a packaging bag.

### Background Art

The flexible packaging materials are generally formed by laminating a plurality of films. A film made of polyester such as polyethylene terephthalate is used in order to impart strength and heat resistance to the packaging material, a film made of polyamide 6 is used in order to impart pinhole resistance, and a film made of polypropylene is used in order to impart strength and water vapor barrier properties. These films are usually biaxially stretched to impart printability.

Such a biaxially oriented film is printed if necessary, and an unstretched film made of polyethylene or polypropylene which is not stretched is usually laminated on the printed surface side. A packaging bag is produced from the laminate composed of the plurality of films by heat-sealing the inner sides of the unstretched film made of polyethylene or polypropylene.

In order to impart barrier properties to the packaging bag, an aluminum foil, a film vapor-deposited with aluminum, alumina or silicon oxide, a layer made of an ethylene-vinyl alcohol copolymer or polyvinyl alcohol, or the like is provided between the biaxially oriented film and the unstretched film.

The flexible packaging material satisfies required performance and can be used as a packaging material for packaging various contents by laminating a plurality of different materials. In recent years, in order to reduce the emission of carbon dioxide, which is considered to be a major cause of global warming, such flexible packaging materials are also required to be recycled. Since it is very difficult to recycle packaging materials made of different materials, the shift to mono-materials made of a single material as a means for recycling flexible packaging materials has become a growing trend. As a material for the shift to mono-materials, polyolefin which is easily recycled is considered to be preferable.

The packaging bag for heat sterilization is subjected to a boiling treatment or a retort treatment after the packaging bag is filled with contents and sealed. Alternatively, heated contents may be filled. Since the packaging bag is heat-treated in such treatments, it is appropriate to use polypropylene, which has higher heat resistance than polyethylene, for the unstretched film to be sealed by heat-sealing. When polypropylene is used as a constituent material of the packaging material, suitability as a packaging material such as printability, barrier properties, heat sealability and lamination suitability is imparted to a film made of polypropylene. The printing is performed on a biaxially oriented polypropylene film having strength. The heat-sealing is performed using an unstretched polypropylene film.

In order to impart barrier properties to the packaging material while enabling recycling, it is considered appropriate to use a polypropylene film on which alumina or silicon oxide is vapor-deposited. Therefore, as a film for a mono-material packaging material, a film obtained by vapor-depositing an inorganic oxide such as alumina or silicon oxide on a polypropylene film has been proposed.

However, even when the inorganic oxide is vapor-deposited on the surface of the polypropylene film, the barrier performance may not be exhibited due to fine irregularities at the surface of the oriented polypropylene film. In addition, the adhesion strength between the vapor-deposited inorganic oxide and the surface of the polypropylene film is low, and the physical properties of the laminate may be insufficient. Therefore, in order to compensate for the disadvantage of the polypropylene film with respect to vapor deposition, it has been proposed to provide a layer containing a resin material having a melting point of 180°C or higher on one surface of a biaxially oriented polypropylene film and to vapor-deposit an inorganic oxide on the surface of this layer (Patent Literature 1).

### Citation List

### Patent Literature

PTL 1: Japanese Unexamined Patent Application Publication No. 2022-7964

### Summary of Invention

### Technical Problem

PTL 1 discloses polyamide as the resin material having a melting point of 180°C or higher. Among polyamide resins, when an amorphous aromatic polyamide which is a polyamide resin containing a certain amount or more of an isophthalic acid unit as a constitutional unit is adopted, it becomes easy to form a film. Therefore, for the purpose of improving the film-forming properties, it is considered to employ the amorphous aromatic polyamide as the resin material having a melting point of 180°C or higher.

However, some of the barrier films in which a layer containing the amorphous aromatic polyamide is provided on one surface of a polypropylene film and an inorganic oxide is vapor-deposited on the surface of this layer are inferior in retort resistance; for example, the barrier properties after retort treatment are deteriorated.

In addition, when heat sterilization such as retort treatment is performed on the packaging bag, the film constituting the packaging bag expands or contracts, stress is generated between the layers, and delamination may occur between the layers of the film due to heating in a state in which stress acts between the layers. In polymer films in which a layer containing a polyamide resin is provided on one surface of a polypropylene film, suppression of delamination has been in demand.

Therefore, an object of the present disclosure is to provide a barrier film which can suppress delamination and is excellent in film-forming properties, recyclability, and retort resistance.

Another object of the present disclosure is to provide a laminate and a packaging bag using the barrier film.

### Solution to Problem

The present inventors have found that, in a layer containing an amorphous aromatic polyamide provided on one surface of a polypropylene film, by adjusting the ratio of the number of aromatic diamine units within a certain range while maintaining the content of the amorphous aromatic polyamide at a certain level or more, and vapor-depositing an inorganic oxide on the surface of this layer, a barrier film having excellent retort resistance while having improved film-forming properties is obtained.

In addition, the present inventors have paid attention to the fact that an acid-modified product of polypropylene is a polypropylene-based resin having excellent adhesion properties, and have found that when a layer containing the acid-modified product of polypropylene is provided between a polypropylene film and a layer containing polyamide, delamination can be suppressed without impairing recyclability.

The present disclosure has been completed through further studies based on these findings.

The present disclosure includes the following embodiments.
<1> A barrier film including a vapor deposition film on a side of a first resin layer of a polymer film,
   wherein the polymer film includes the first resin layer, a second resin layer, and a third resin layer in this order,
   the first resin layer constitutes one outermost layer of the polymer film,
   the first resin layer includes a polyamide resin, the polyamide resin includes an aromatic polyamide,
   a ratio of a number of diamine units contained in the aromatic polyamide to a total number of aminocarboxylic acid units and diamine units contained in the polyamide resin constituting the first resin layer is 85 mol% or more,
   a ratio of a number of aromatic diamine units contained in the aromatic polyamide to the total number of aminocarboxylic acid units and diamine units contained in the polyamide resin constituting the first resin layer is 15 mol% or more and 70 mol% or less,
   a content of an amorphous aromatic polyamide in the first resin layer is 25 mass% or more,
   the second resin layer includes an acid-modified product of polypropylene,
   the third resin layer includes homopolypropylene, and
   the vapor deposition film includes an inorganic oxide.
<2> The barrier film according to <1>, wherein the polyamide resin included in the first resin layer is of two types, a first polyamide and a second polyamide,
   the first polyamide is the amorphous aromatic polyamide, and
   the second polyamide is a crystalline aromatic polyamide.
<3> The barrier film according to <1>, wherein the polyamide resin included in the first resin layer is of three types, a first polyamide, a second polyamide, and a third polyamide,
   the first polyamide is the amorphous aromatic polyamide,
   the second polyamide is a crystalline aromatic polyamide, and
   the third polyamide is an aliphatic polyamide.
<4> The barrier film according to <3>, wherein a content of the third polyamide in the first resin layer is 1 mass% or more and 75 mass% or less.
<5> The barrier film according to any one of <2> to <4>, wherein a content of the first polyamide in the first resin layer is 25 mass% or more and 95 mass% or less.
<6> The barrier film according to any one of <2> to <5>, wherein a content of the second polyamide in the first resin layer is 5 mass% or more and 75 mass% or less.
<7> The barrier film according to any one of <1> to <6>, wherein a content of polypropylene in the polymer film is 70 mass% or more.
<8> The barrier film according to any one of <1> to <7>, wherein a thickness of the third resin layer is largest among thicknesses of the first resin layer, the second resin layer, and the third resin layer, and
   thicknesses of layers constituting the polymer film satisfy the following formulae (1) and (2): $Thickness of first resin layer \leq \left(Thickness of polymer film\right) / 10$ (1) $Thickness of second resin layer \leq \left(Thickness of polymer film\right) / 5$ (2)
<9> The barrier film according to any one of <1> to <8>, wherein the polymer film includes a fourth resin layer on a side of the third resin layer opposite the second resin layer, and
   the fourth resin layer includes a copolymer of propylene and an olefin other than propylene.
<10> The barrier film according to any one of <1> to <9>, further including a barrier coat layer on a side of the vapor deposition film.
<11> A laminate including the barrier film according to any one of <1> to <10> and a heat sealant film.
<12> The laminate according to <11>, further including a polypropylene base film.
<13> The laminate according to <11> or <12>, including a polypropylene base film on a side of the barrier film opposite the heat sealant film,
   wherein when a film including the polypropylene base film and a film including the barrier film and the heat sealant film are peeled from each other in accordance with JIS K 6854-2:1999 after retort treatment at 121°C and 0.2 MPa for 30 minutes, a wet peel strength is 0.3 N/15 mm or more.
<14> A packaging bag including the laminate according to any one of <11> to <13>.
<15> The packaging bag according to <14>, which is a heat-sterilized food pouch.
<16> The packaging bag according to <15>, wherein the laminate includes a polypropylene base film on a side of the barrier film opposite the heat sealant film, and
   when a film including the polypropylene base film and a film including the barrier film and the heat sealant film are peeled from each other in accordance with JIS K 6854-2:1999, a wet peel strength is 0.3 N/15 mm or more.

### Advantageous Effects of Invention

The present disclosure can provide a barrier film which can suppress delamination and is excellent in film-forming properties, recyclability, and retort resistance.

In addition, the present disclosure can provide a laminate and a packaging bag using the barrier film.

### Brief Description of Drawings

[Fig. 1] Fig. 1 is a schematic cross-sectional view showing an embodiment of a polymer film used in the present disclosure.
[Fig. 2] Fig. 2 is a schematic cross-sectional view showing another embodiment of the polymer film used in the present disclosure.
[Fig. 3] Fig. 3 is a schematic cross-sectional view showing an embodiment of a barrier film according to the present disclosure.
[Fig. 4] Fig. 4 is a schematic cross-sectional view showing another embodiment of the barrier film according to the present disclosure.
[Fig. 5] Fig. 5 is a schematic cross-sectional view in which a barrier coat layer is provided in an embodiment of the barrier film according to the present disclosure.
[Fig. 6] Fig. 6 is a schematic cross-sectional view showing an embodiment of a laminate according to the present disclosure.
[Fig. 7] Fig. 7 is a schematic cross-sectional view showing another embodiment of the laminate according to the present disclosure.
[Fig. 8] Fig. 8 is a graph showing a change in tensile stress with respect to a distance between a pair of grips for pulling two films to measure peel strength.
[Fig. 9] Fig. 9 is a front view showing an embodiment of a packaging bag according to the present disclosure.

### Description of Embodiments

In the present specification, in a case where a plurality of upper limit value candidates and a plurality of lower limit value candidates are listed for a certain parameter, the numerical range of the parameter may be defined by combining any one upper limit value candidate and any one lower limit value candidate. As an example, a description "the parameter B is preferably A1 or more, more preferably A2 or more, and further preferably A3 or more, and is preferably A4 or less, more preferably A5 or less, and further preferably A6 or less" will be described. In this example, the numerical range of the parameter B may be A1 or more and A4 or less, A1 or more and A5 or less, A1 or more and A6 or less, A2 or more and A4 or less, A2 or more and A5 or less, A2 or more and A6 or less, A3 or more and A4 or less, A3 or more and A5 or less, or A3 or more and A6 or less.

### (Polymer film)

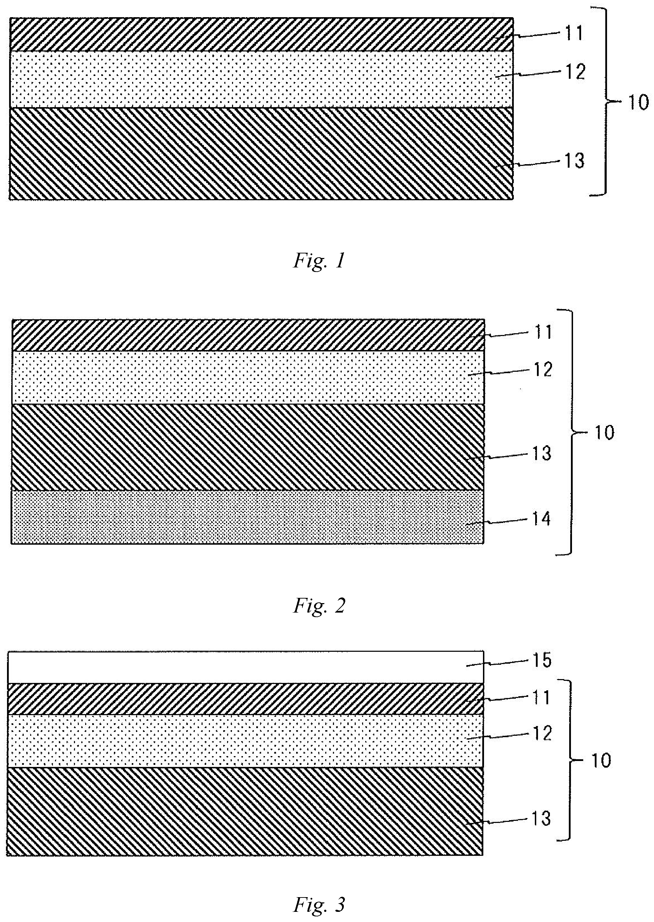

Fig. 1 shows a schematic cross-sectional view of a polymer film 10 used in a barrier film of the present disclosure. The polymer film 10 includes a first resin layer 11, a second resin layer 12, and a third resin layer 13 in this order. The first resin layer 11 constitutes one outermost layer of the polymer film 10. The third resin layer 13 constitutes the other outermost layer of the polymer film 10.

A schematic cross-sectional view of another embodiment of the polymer film 10 used in the barrier film of the present disclosure is shown in Fig. 2. The polymer film 10 includes a first resin layer 11, a second resin layer 12, a third resin layer 13, and a fourth resin layer 14 in this order. The first resin layer 11 constitutes one outermost layer of the polymer film 10. The fourth resin layer 14 constitutes the other outermost layer of the polymer film 10.

As shown in Fig. 3, a vapor deposition film 15 is provided on the first resin layer side of the polymer film 10 to obtain the barrier film of the present disclosure.

The surface roughness Sa of one outermost surface of the polymer film 10 is preferably 0.10 µm or less, more preferably 0.07 µm or less, still more preferably 0.05 µm or less, and is preferably 0.01 µm or more, more preferably 0.02 µm or more, still more preferably 0.03 µm or more. As the surface roughness Sa of one outermost surface of the polymer film 10 is smaller, the surface of the first resin layer in the polymer film 10 is smoother, and the resin constituting the first resin layer is more suitable for film formation.

For example, the surface roughness Sa of one outermost surface of the polymer film 10 is preferably 0.01 µm or more and 0.10 µm or less, more preferably 0.02 µm or more and 0.07 µm or less, and still more preferably 0.03 µm or more and 0.05 µm or less.

The surface roughness Sa of the other outermost surface of the polymer film 10 is preferably 0.20 µm or less, more preferably 0.17 µm or less, still more preferably 0.14 µm or less, and is preferably 0.05 µm or more, more preferably 0.07 µm or more, still more preferably 0.09 µm or more. As the surface roughness Sa of the other outermost surface of the polymer film 10 is larger, the other outermost surface in the polymer film 10 is rougher, and the difference from the surface roughness Sa of the one outermost surface is larger. As a result, it is possible to suppress a blocking phenomenon in which the other outermost layer adheres to one outermost layer when the polymer film 10 is wound in a roll shape.

For example, the surface roughness Sa of the other outermost surface of the polymer film 10 is preferably 0.05 µm or more and 0.20 µm or less, more preferably 0.07 µm or more and 0.17 µm or less, and still more preferably 0.09 µm or more and 0.14 µm or less.

Hereinafter, each layer included in the polymer film 10 will be described.

### (First resin layer)

The first resin layer 11 includes a polyamide resin, and the polyamide resin includes an aromatic polyamide. The aromatic polyamide is a polyamide resin containing a benzene ring. Examples of the aromatic polyamide include those obtained by subjecting copolymers of an aromatic diamine and an aliphatic dicarboxylic acid, copolymers of an aliphatic diamine and a dicarboxylic acid containing a benzene ring, copolymers of an aromatic diamine and a dicarboxylic acid containing a benzene ring, and copolymers of an aromatic diamine and an aliphatic dicarboxylic acid to further copolymerization with at least one selected from the group consisting of aliphatic diamines and dicarboxylic acids containing a benzene ring; and those obtained by subjecting copolymers of an aliphatic diamine and a dicarboxylic acid containing a benzene ring to further copolymerization with at least one selected from the group consisting of aromatic diamines and aliphatic carboxylic acids. Two or more diamines and two or more dicarboxylic acids may be used.

The aromatic diamine is a diamine containing a benzene ring, and examples thereof include metaxylenediamine, paraxylenediamine, metaphenylenediamine, and paraphenylenediamine. One or more of these are used.

Examples of the dicarboxylic acid containing a benzene ring include aromatic dicarboxylic acids such as terephthalic acid (TPA) and isophthalic acid (IPA), and naphthalenedicarboxylic acids such as 1,2-naphthalenedicarboxylic acid, 1,3-naphthalenedicarboxylic acid, 1,4-naphthalenedicarboxylic acid, 1,5-naphthalenedicarboxylic acid, 1,6-naphthalenedicarboxylic acid, 1,7-naphthalenedicarboxylic acid, 1,8-naphthalenedicarboxylic acid, 2,3-naphthalenedicarboxylic acid, 2,6-naphthalenedicarboxylic acid, and 2,7-naphthalenedicarboxylic acid. One or more of these are used.

Examples of the aliphatic diamine include linear aliphatic diamines such as 1,4-butanediamine, 1,5-pentanediamine, 1,6-hexanediamine (hexamethylenediamine), 1,7-heptanediamine, 1,8-octanediamine, 1,9-nonanediamine (NDA), 1,10-decanediamine (DDA), 1,11-undecanediamine, and 1,12-dodecane diamine; branched aliphatic diamines such as 2-methyl-1,8-octanediamine (MODA), 4-methyl-1,8-octanediamine, 5-methyl-1,9-nonanediamine, 2,2,4-/2,4,4-trimethyl-1,6-hexanediamine, 2-methyl-1,5-pentanediamine, 2-methyl-1,6-hexanediamine, and 2-methyl-1,7-heptanediamine; and alicyclic diamines such as isophoronediamine, norbornanedimethylamine, and tricyclodecanedimethylamine. One or more of these are used.

The aliphatic dicarboxylic acid is an aliphatic dicarboxylic acid having 2 or more and 20 or less carbon atoms. In view of, for example, polymerizability and processability, adipic acid is most preferred, and examples of other dicarboxylic acids include oxalic acid, malonic acid, succinic acid, glutaric acid, pimelic acid, suberic acid, azelaic acid, sebacic acid, undecanedioic acid, dodecadioic acid, hexadecadioic acid, eicosanedioic acid, eicosadienedioic acid and 2,2,4-trimethyladipic acid. One or more of these are used.

The first resin layer 11 may contain an aliphatic polyamide as the polyamide resin. The aliphatic polyamide is a polyamide resin containing no benzene ring. Examples of the aliphatic polyamide include polyamides 6, 7, 10, 11, 12, 410, 56, 66, 69, 610, 611, 612, and 1010. The first resin layer 11 may contain one or more of these materials.

In addition, the first resin layer 11 may contain a resin other than polyamide, such as polyester, an acrylic resin, or an ionomer resin, as long as processability and physical properties are not affected.

The ratio of the number of diamine units contained in the aromatic polyamide to the total number of aminocarboxylic acid units and diamine units contained in the polyamide resin constituting the first resin layer is 85 mol% or more, preferably 88 mol% or more, more preferably 92 mol% or more, and still more preferably 95 mol% or more. The upper limit value of the ratio of the number of diamine units contained in the aromatic polyamide to the total number of aminocarboxylic acid units and diamine units contained in the polyamide resin constituting the first resin layer is 100 mol%.

For example, the ratio of the number of diamine units contained in the aromatic polyamide to the total number of aminocarboxylic acid units and diamine units contained in the polyamide resin constituting the first resin layer is preferably 85 mol% or more and 100 mol% or less, more preferably 88 mol% or more and 100 mol% or less, further preferably 92 mol% or more and 100 mol% or less, and still further preferably 95 mol% or more and 100 mol% or less.

Examples of the polyamide resin include a polyamide resin obtained by ring-opening polymerization of lactam (ring-opening polymerized polyamide) and a polyamide resin obtained by copolymerization of diamine and dicarboxylic acid (copolymerized polyamide). The aminocarboxylic acid unit is a constitutional unit of the ring-opening polymerized polyamide. The dicarboxylic acid unit is one of the constitutional units of the copolymerized polyamide. The "total number of aminocarboxylic acid units and diamine units contained in the polyamide resin constituting the first resin layer" corresponds to the total amount of substance (mol) of the aminocarboxylic acid units and the diamine units contained in the polyamide resin constituting the first resin layer, and represents the amount of all the polyamide resins constituting the first resin layer. The number of "diamine units contained in the aromatic polyamide" corresponds to the amount of substance (mol) of the diamine units contained in the aromatic polyamide, and represents the amount of the aromatic polyamide. Therefore, the "ratio of the number of diamine units contained in the aromatic polyamide to the total number of aminocarboxylic acid units and diamine units contained in the polyamide resin constituting the first resin layer" represents the ratio of the aromatic polyamide to all the polyamide resins constituting the first resin layer.

A method for theoretically calculating the ratio of the number of diamine units contained in the aromatic polyamide to the total number of aminocarboxylic acid units and diamine units contained in the polyamide resin constituting the first resin layer will be described with reference to examples.

For example, when all of the polyamide resins constituting the first resin layer are aromatic polyamides, the ratio of the number of diamine units contained in the aromatic polyamides to the total number of aminocarboxylic acid units and diamine units contained in the polyamide resins constituting the first resin layer is 100 mol%.

Next, the case where the polyamide resins constituting the first resin layer are composed of 5 mass% of polyamide 6 and 95 mass% of polyamide 6l (copolymer of 1,6-hexanediamine and isophthalic acid) will be described. Polyamide 6 contains 6-aminohexanoic acid units (-NH-(CH₂)₅-CO-, molecular weight: 113) as the aminocarboxylic acid units. The polyamide 6l contains 1,6-hexanediamine units (-NH-(CH₂)₆-NH-, molecular weight: 114) as the diamine units and isophthalic acid units (-CO-C₆H₄-CO-, molecular weight: 132) as the dicarboxylic acid units in equal numbers. Therefore, the ratio of the number of the diamine units contained in the aromatic polyamide to the total number of the aminocarboxylic acid units and the diamine units contained in the polyamides constituting the first resin layer is {95/(114 + 132)} ÷ [(5/113) + {95/(114 + 132)}] ×100 = 89.7 mol%.

When the ratio of the number of diamine units contained in the aromatic polyamide to the total number of aminocarboxylic acid units and diamine units contained in the polyamide resin constituting the first resin layer is equal to or greater than the lower limit value, the retort resistance of the barrier film is improved.

The ratio of the number of aromatic diamine units contained in the aromatic polyamide to the total number of aminocarboxylic acid units and diamine units contained in the polyamide resin constituting the first resin layer is 15 mol% or more, preferably 18 mol% or more, more preferably 21 mol% or more, and even more preferably 24 mol% or more, and 70 mol% or less, preferably 50 mol% or less, more preferably 40 mol% or less, and even more preferably 30 mol% or less.

For example, the ratio of the number of aromatic diamine units contained in the aromatic polyamide to the total number of aminocarboxylic acid units and diamine units contained in the polyamide resin constituting the first resin layer is 15 mol% or more and 70 mol% or less, preferably 18 mol% or more and 50 mol% or less, more preferably 21 mol% or more and 40 mol% or less, still more preferably 24 mol% or more and 30 mol% or less.

As described above, the "total number of aminocarboxylic acid units and diamine units contained in the polyamide resin constituting the first resin layer" represents the amount of all the polyamide resins constituting the first resin layer; therefore, the "ratio of the number of aromatic diamine units contained in the aromatic polyamide to the total number of aminocarboxylic acid units and diamine units contained in the polyamide resin constituting the first resin layer" is an index indicating to what extent the aromatic diamine units are contained in all the polyamide resins constituting the first resin layer.

A method for theoretically calculating the ratio of the number of aromatic diamine units contained in the aromatic polyamide to the total number of aminocarboxylic acid units and diamine units contained in the polyamide resin constituting the first resin layer will be described with reference to examples.

First, the case where the polyamide resins constituting the first resin layer are composed of 60 mass% of polyamide 6 and 40 mass% of MXD6 (copolymer of metaxylenediamine and adipic acid) will be described. Polyamide 6 contains 6-aminohexanoic acid units (-NH-(CH₂)₅-CO-, molecular weight: 113) as aminocarboxylic acid units. MXD6 contains metaxylenediamine units (-NH-CH₂-C₆H₄-CH₂-NH-, molecular weight: 134) as diamine units and adipic acid units (-CO-(CH₂)₄-CO-, molecular weight: 112) as dicarboxylic acid units in equal numbers. The metaxylenediamine units correspond to aromatic diamine units. Therefore, the ratio of the number of the aromatic diamine units contained in the aromatic polyamide to the total number of the aminocarboxylic acid units and the diamine units contained in the polyamide resins constituting the first resin layer is {40/(134 + 112)} ÷ [(60/113) + {40/(134 + 112)}] ×100 = 23.4 mol%.

Next, the case where the polyamide resins constituting the first resin layer are composed of 60 mass% of MXD6 and 40 mass% of polyamide 6l (copolymer of 1,6-hexanediamine and isophthalic acid) will be described. In this case, the polyamide resins do not contain an aminocarboxylic acid unit. MXD6 contains metaxylenediamine units (-NH-CH₂-C₆H₄-CH₂-NH-, molecular weight: 134) as diamine units and adipic acid units (-CO-(CH₂)₄-CO-, molecular weight: 112) as dicarboxylic acid units in equal numbers. Polyamide 6l contains 1,6-hexanediamine units (-NH-(CH₂)₆-NH-, molecular weight: 114) as diamine units and isophthalic acid units (-CO-C₆H₄-CO-, molecular weight: 132) as dicarboxylic acid units in equal numbers. The metaxylenediamine units correspond to aromatic diamine units. The 1,6-hexanediamine units correspond to diamine units, but do not correspond to aromatic diamine units. Therefore, the ratio of the number of the aromatic diamine units contained in the aromatic polyamide to the total number of the aminocarboxylic acid units and the diamine units contained in the polyamide resins constituting the first resin layer is {60/(134 + 112)} ÷ [{60/(134 + 112)} + {40/(114 + 132)}] ×100 = 60 mol%.

When the ratio of the number of aromatic diamine units contained in the aromatic polyamide to the total number of aminocarboxylic acid units and diamine units contained in the polyamide resin constituting the first resin layer is within a certain range, the retort resistance of the barrier film is improved.

In practice, the "ratio of the number of diamine units contained in the aromatic polyamide to the total number of aminocarboxylic acid units and diamine units contained in the polyamide resin constituting the first resin layer" and the "ratio of the number of aromatic diamine units contained in the aromatic polyamide to the total number of aminocarboxylic acid units and diamine units contained in the polyamide resin constituting the first resin layer" are obtained from the measurement results of a ¹H-NMR spectrum. Specifically, the "ratio of the number of diamine units contained in the aromatic polyamide to the total number of aminocarboxylic acid units and diamine units contained in the polyamide resin constituting the first resin layer" and the "ratio of the number of aromatic diamine units contained in the aromatic polyamide to the total number of aminocarboxylic acid units and diamine units contained in the polyamide resin constituting the first resin layer" can be determined by measuring the ¹H-NMR spectrum and calculating the ratio of the number of aminocarboxylic acid units and the ratio of the number of diamine units contained in the first resin layer.

The proton from which a peak observed in the measurement of the ¹H-NMR spectrum is derived can be identified by, for example, comparing with the measurement results of the ¹H-NMR spectra of known polyamide resins. From the area ratios of peaks, the ratio of the number of aminocarboxylic acid units and the ratio of the number of diamine units contained in the first resin layer can be obtained.

When a measurement sample is prepared from a polymer film and the ¹H-NMR spectrum is measured, the ¹H-NMR spectrum is measured as follows.

The polymer film is cut into pieces with scissors and placed in a sample vial. Chloroform (6 mL) and formic acid (4 mL) are added to the sample vial, and the mixture is allowed to stand overnight. In this way, the first resin layer constituting the polymer film is dissolved in the mixed solvent of chloroform and formic acid.

The organic solvent phase is filtered through a Chromatodisk having a filter pore size of 0.45 µm, and concentrated and dried to dryness using a nitrogen blower to be prepared as a measurement sample.

The measurement sample (20 to 30 mg) is dissolved in a mixed solvent of deuterated chloroform (CDCl₃, 0.5 mL) and formic acid (0.5 mL), and transferred to an NMR sample tube.

The ¹H-NMR spectrum is measured using an NMR apparatus (manufactured by Bruker Japan K.K., AVANCE III HD 400 MHz) under the following measurement conditions.

### (Measurement conditions)

·Observed nucleus: ¹H
·Measurement temperature: room temperature
·Number of scans: 32
·Relaxation delay: 5 s
·Probe: PA BBO 400S1 BBF-H-D-05 Z SP
·Deuterated solvent: CDCl₃ (internal standard: TMS) + formic acid
·Window function: exponential
·Line broadening: 0.3 Hz

When the ¹H-NMR spectrum is measured using a measurement sample prepared from the barrier film, the ¹H-NMR spectrum is measured in the same manner as in the case where the ¹H-NMR spectrum is measured using a measurement sample prepared from the polymer film.

When a measurement sample is prepared from the laminate and the ¹H-NMR spectrum is measured, the ¹H-NMR spectrum is measured as follows.

The laminate is cut into pieces with scissors, subjected to cryogenic grinding, and then placed in a sample vial. A mixed solvent of chloroform:formic acid =1:1 is added to the sample vial, and the mixture is treated in an ultrasonic cleaner for 10 minutes and then allowed to stand overnight.

The organic solvent phase is filtered through a Chromatodisk with a filter pore size of 0.45 µm, and concentrated and dried to dryness using a nitrogen blower. Chloroform (10 mL) is added to the dried product, and the mixture is treated in an ultrasonic cleaner for 2 to 3 minutes. The solution is filtered through a 5C filter paper and the filter cake is washed with chloroform.

After drying the filter cake together with the 5C filter paper by nitrogen blowing, the filter cake is dissolved in formic acid, and the filtrate is collected. The collected filtrate is dried by nitrogen blowing to obtain a measurement sample.

Thereafter, the ¹H-NMR spectrum is measured in the same manner as described above.

Aromatic polyamides are classified into crystalline aromatic polyamides and amorphous aromatic polyamides.

In the present disclosure, the amorphous polyamide means a polyamide having no definite melting point, and specifically means a polyamide having an enthalpy of fusion ΔHm of 5 J/g or less. The enthalpy of fusion is preferably 3 J/g or less, more preferably 1 J/g or less.

In the present disclosure, the crystalline polyamide means a polyamide having a definite melting point, and specifically means a polyamide having an enthalpy of fusion ΔHm of more than 5 J/g.

The enthalpy of fusion is obtained by differential scanning calorimetry (DSC) in accordance with JIS K 7121:2012 and JIS K 7122:2012.

Examples of the crystalline aromatic polyamide include a copolymer of metaxylenediamine and adipic acid, and a copolymer of metaxylenediamine with adipic acid and isophthalic acid.

Examples of the copolymer of metaxylenediamine with adipic acid and isophthalic acid include a copolymer of metaxylenediamine with dicarboxylic acids having a molar ratio of adipic acid/isophthalic acid of 93/7 and a copolymer of metaxylenediamine with dicarboxylic acids having a molar ratio of adipic acid/isophthalic acid of 8/2.

Examples of the amorphous aromatic polyamide include a copolymer of 1,6-hexanediamine and isophthalic acid, a copolymer of metaxylenediamine and isophthalic acid, a copolymer of 1,6-hexanediamine with isophthalic acid and terephthalic acid, a copolymer of metaxylenediamine with adipic acid and isophthalic acid, a copolymer of 1,6-hexanediamine and metaxylenediamine with adipic acid and isophthalic acid, a copolymer of 2-methyl-1,5-pentanediamine with isophthalic acid and terephthalic acid, and a copolymer of 2,2,4-trimethylhexamethylenediamine and terephthalic acid.

Examples of the copolymer of 1,6-hexanediamine with isophthalic acid and terephthalic acid include a copolymer of 1,6-hexanediamine with dicarboxylic acids having a molar ratio of isophthalic acid/terephthalic acid of 7/3, and a copolymer of 1,6-hexanediamine with dicarboxylic acids having a molar ratio of isophthalic acid/terephthalic acid of 1/1. Examples of the copolymer of metaxylenediamine with adipic acid and isophthalic acid include a copolymer of metaxylenediamine with dicarboxylic acids having a molar ratio of adipic acid/isophthalic acid of 1/1. The copolymer of 1,6-hexanediamine and metaxylenediamine with adipic acid and isophthalic acid include a copolymer of diamines having a molar ratio of 1,6-hexanediamine/metaxylenediamine of 1/1 and dicarboxylic acids having a molar ratio of adipic acid/isophthalic acid of 1/1. Examples of the copolymer of 2-methyl-1,5-pentanediamine with isophthalic acid and terephthalic acid include a copolymer of 2-methyl-1,5-pentanediamine with dicarboxylic acids having a molar ratio of isophthalic acid/terephthalic acid of 7/3.

The content of the amorphous aromatic polyamide in the first resin layer is 25 mass% or more, preferably 40 mass% or more, more preferably 55 mass% or more, and still more preferably 70 mass% or more. When the content of the amorphous aromatic polyamide in the first resin layer is equal to or greater than the lower limit value, the film-forming properties are improved. The upper limit value of the content of the amorphous aromatic polyamide in the first resin layer is 100 mass%.

For example, the content of the amorphous aromatic polyamide in the first resin layer is preferably 25 mass% or more and 100 mass% or less, more preferably 40 mass% or more and 100 mass% or less, further preferably 55 mass% or more and 100 mass% or less, and still further preferably 70 mass% or more and 100 mass% or less.

The polyamide resin contained in the first resin layer may be of one type or two or more types. When the polyamide resin contained in the first resin layer is of one type, the ratio of the number of aromatic diamine units contained in the aromatic polyamide to the total number of aminocarboxylic acid units and diamine units contained in the polyamide resin constituting the first resin layer can be adjusted within the above range by appropriately adjusting the types and ratios of monomers used for synthesis of the polyamide resin. For example, when the first resin layer is formed of an aromatic polyamide obtained by polycondensation of diamines containing 15 mol% or more and 70 mol% or less of metaxylenediamine and any dicarboxylic acid, the ratio of the number of aromatic diamine units contained in the aromatic polyamide to the total number of aminocarboxylic acid units and diamine units contained in the polyamide resin constituting the first resin layer can be adjusted to 15 mol% or more and 70 mol% or less.

Alternatively, the ratio of the number of aromatic diamine units contained in the aromatic polyamide to the total number of aminocarboxylic acid units and diamine units contained in the polyamide resin constituting the first resin layer may be adjusted within the above-described range by forming the first resin layer with a resin composition in which two or more polyamide resins are mixed at an appropriate ratio. From the viewpoint that the ratio of the number of aromatic diamine units contained in the aromatic polyamide to the total number of aminocarboxylic acid units and diamine units contained in the polyamide resin constituting the first resin layer can be easily adjusted, it is preferable that the first resin layer contains two or more polyamides.

When the polyamide resin contained in the first resin layer is of one type, the content of the polyamide resin in the first resin layer is 25 mass% or more, preferably 70 mass% or more, more preferably 80 mass% or more, and still more preferably 90 mass% or more. When the polyamide resin contained in the first resin layer is of one type, the upper limit value of the content of the polyamide resin in the first resin layer is 100 mass%.

For example, when the first resin layer contains one polyamide resin, the content of the polyamide resin in the first resin layer is preferably 25 mass% or more and 100 mass% or less, more preferably 70 mass% or more and 100 mass% or less, further preferably 80 mass% or more and 100 mass% or less, and still further preferably 90 mass% or more and 100 mass% or less.

In the present disclosure, since the first resin layer contains an amorphous aromatic polyamide as the polyamide resin, when the polyamide resin contained in the first resin layer is of one type, the polyamide resin is the amorphous aromatic polyamide.

Next, the case where the polyamide resin contained in the first resin layer is of two types, a first polyamide and a second polyamide, will be described.

In the present disclosure, since the first resin layer contains an amorphous aromatic polyamide as the polyamide resin, the first polyamide is the amorphous aromatic polyamide.

The second polyamide may be an amorphous aromatic polyamide, a crystalline aromatic polyamide, or an aliphatic polyamide. In particular, the second polyamide is preferably a crystalline aromatic polyamide, and more preferably a crystalline aromatic polyamide containing an aromatic diamine unit, from the viewpoint that the ratio of the number of aromatic diamine units contained in the aromatic polyamide to the total number of aminocarboxylic acid units and diamine units contained in the polyamide resin constituting the first resin layer can be easily adjusted.

When the polyamide resin contained in the first resin layer is of two types, the first polyamide and the second polyamide, the content of the first polyamide in the first resin layer is 25 mass% or more, preferably 40 mass% or more, more preferably 55 mass% or more, and further preferably 70 mass% or more, and is preferably 95 mass% or less, more preferably 85 mass% or less, and further preferably 75 mass% or less.

For example, in the case where the polyamide resin contained in the first resin layer is of two types, the first polyamide and the second polyamide, the content of the first polyamide in the first resin layer is preferably 25 mass% or more and 95 mass% or less, more preferably 40 mass% or more and 85 mass% or less, further preferably 55 mass% or more and 75 mass% or less, and still further preferably 70 mass% or more and 75 mass% or less.

When the polyamide resin contained in the first resin layer is of two types, the first polyamide and the second polyamide, the content of the second polyamide in the first resin layer is preferably 5 mass% or more, more preferably 15 mass% or more, and further preferably 25 mass% or more, and is 75 mass% or less, preferably 60 mass% or less, more preferably 45 mass% or less, and further preferably 30 mass% or less.

For example, when the polyamide resin contained in the first resin layer is of two types, the first polyamide and the second polyamide, the content of the second polyamide in the first resin layer is preferably 5 mass% or more and 75 mass% or less, more preferably 15 mass% or more and 60 mass% or less, still more preferably 25 mass% or more and 45 mass% or less, and still more preferably 25 mass% or more and 30 mass% or less.

Next, the case where the polyamide resin contained in the first resin layer is of three types, a first polyamide, a second polyamide, and a third polyamide, will be described.

In the present disclosure, since the first resin layer contains an amorphous aromatic polyamide as the polyamide resin, the first polyamide is the amorphous aromatic polyamide.

The second polyamide may be an amorphous aromatic polyamide, a crystalline aromatic polyamide, or an aliphatic polyamide. In particular, the second polyamide is preferably a crystalline aromatic polyamide, and more preferably a crystalline aromatic polyamide containing an aromatic diamine unit, from the viewpoint that the ratio of the number of aromatic diamine units contained in the aromatic polyamide to the total number of aminocarboxylic acid units and diamine units contained in the polyamide resin constituting the first resin layer can be easily adjusted.

The third polyamide may be an amorphous aromatic polyamide, a crystalline aromatic polyamide, or an aliphatic polyamide. Among these, from the viewpoint of cost reduction, the third polyamide is preferably an aliphatic polyamide.

When the polyamide resin contained in the first resin layer is of three types, the first polyamide, the second polyamide, and the third polyamide, the content of the first polyamide in the first resin layer is 25 mass% or more, preferably 40 mass% or more, more preferably 55 mass% or more, and further preferably 70 mass% or more, and is preferably 95 mass% or less, more preferably 85 mass% or less, and further preferably 75 mass% or less.

For example, when the polyamide resin contained in the first resin layer is of three types, the first polyamide, the second polyamide, and the third polyamide, the content of the first polyamide in the first resin layer is preferably 25 mass% or more and 95 mass% or less, more preferably 40 mass% or more and 85 mass% or less, further preferably 55 mass% or more and 75 mass% or less, and still further preferably 70 mass% or more and 75 mass% or less.

When the polyamide resin contained in the first resin layer is of three types, the first polyamide, the second polyamide, and the third polyamide, the content of the second polyamide in the first resin layer is preferably 5 mass% or more, more preferably 15 mass% or more, and even more preferably 25 mass% or more, and is 75 mass% or less, preferably 60 mass% or less, more preferably 45 mass% or less, and even more preferably 30 mass% or less.

For example, when the polyamide resin contained in the first resin layer is of three types, the first polyamide, the second polyamide, and the third polyamide, the content of the second polyamide in the first resin layer is preferably 5 mass% or more and 75 mass% or less, more preferably 15 mass% or more and 60 mass% or less, further preferably 25 mass% or more and 45 mass% or less, and still further preferably 25 mass% or more and 30 mass% or less.

When the polyamide resin contained in the first resin layer is of three types, the first polyamide, the second polyamide, and the third polyamide, the content of the third polyamide in the first resin layer is preferably 1 mass% or more, more preferably 2 mass% or more, and even more preferably 3 mass% or more, and is 75 mass% or less, preferably 25 mass% or less, more preferably 15 mass% or less, and even more preferably 5 mass% or less.

For example, when the polyamide resin contained in the first resin layer is of three types, the first polyamide, the second polyamide, and the third polyamide, the content of the third polyamide in the first resin layer is preferably 1 mass% or more and 75 mass% or less, more preferably 2 mass% or more and 25 mass% or less, further preferably 3 mass% or more and 15 mass% or less, and still further preferably 3 mass% or more and 5 mass% or less.

The first resin layer 11 can include an additive. Examples of the additive include crosslinking agents, antioxidants, anti-blocking agents, lubricants, ultraviolet absorbents, light stabilizers, fillers, reinforcing agents, antistatic agents, pigments, and modifying resins.

The ratio of the thickness of the first resin layer 11 to the total thickness of the polymer film 10 is preferably 1% or more, and more preferably 2% or more. In this case, the gas barrier properties of the polymer film 10 can be improved by the high gas barrier properties of the first resin layer 11, and in addition, the adhesion to the vapor deposition film 15 can be increased, and the gas barrier properties can be further improved. Further, the ratio of the thickness of the first resin layer 11 to the total thickness of the polymer film 10 is preferably 10% or less, and more preferably 5% or less. In this case, the film-forming properties and the processability of the polymer film 10 can be further improved, and the ratio of the constituent materials other than polypropylene in the polymer film 10 can be suppressed to improve the recyclability.

For example, the ratio of the thickness of the first resin layer 11 to the total thickness of the polymer film 10 is preferably 1% or more and 10% or less, and more preferably 2% or more and 5% or less.

The thickness of the first resin layer 11 is preferably 0.1 µm or more, more preferably 0.2 µm or more, and still more preferably 0.3 µm or more. In this case, the gas barrier properties of the polymer film 10 can be improved by the high gas barrier properties of the first resin layer 11, and in addition, the adhesion to the vapor deposition film 15 increases, and the gas barrier properties can be further improved. The thickness of the first resin layer is preferably 5 µm or less, more preferably 4 µm or less, and still more preferably 2 µm or less. In this case, the ratio of the constituent materials other than polypropylene in the polymer film 10 can be suppressed to improve the recyclability.

For example, the thickness of the first resin layer 11 is preferably 0.1 µm or more and 5 µm or less, more preferably 0.2 µm or more and 4 µm or less, and still more preferably 0.3 µm or more and 2 µm or less.

The first resin layer 11 may be subjected to a surface treatment. Thus, the adhesion to the vapor deposition film 15 can be improved. The process of performing the surface treatment is not particularly limited and may be a physical treatment such as a corona discharge treatment, an ozone treatment, or a low-temperature plasma treatment or a glow-discharge treatment using one or more selected from the group consisting of argon gas, oxygen gas and nitrogen gas, or a chemical treatment such as an oxidation treatment using a chemical agent.

### (Third resin layer)

The third resin layer 13 includes a polypropylene resin layer, and the polypropylene resin layer may be a single layer or a multilayer including a regrind layer. When the third resin layer 13 includes a polypropylene resin layer, heat resistance can be imparted to the polymer film 10.

The polypropylene contained in the polypropylene resin layer contains homopolypropylene as a main component, and may contain a polypropylene random copolymer and a polypropylene block copolymer. The polypropylene random copolymer and the polypropylene block copolymer may be contained as a layer or a mixture. The homopolypropylene is a polymer of only propylene, and the polypropylene random copolymer is a random copolymer of propylene and an olefin other than propylene (for example, ethylene, 1-butene, 1-pentene, 4-methyl-1-pentene, 1-hexene, or 1-octene). The polypropylene block copolymer is a copolymer having a polymer block composed of propylene and a polymer block composed of the above-described olefin other than propylene.

The content of the homopolypropylene in the third resin layer 13 is preferably 51 mass% or more, more preferably 60 mass% or more, and still more preferably 70 mass% or more.

In order to impart good transparency to the third resin layer 13, a random copolymer may be added in addition to the homopolypropylene. When a packaging bag is produced using a laminate in which another film is laminated on a barrier film, it is preferable to use only homopolypropylene when rigidity and heat resistance are important, and it is preferable to add a polypropylene random copolymer and/or a polypropylene block copolymer to homopolypropylene or use a polypropylene random copolymer and/or a polypropylene block copolymer when impact resistance and the like are important. Further, biomass-derived polypropylene or mechanically recycled or chemically recycled polypropylene can also be used.

It is preferable that the first resin layer 11 does not contain polypropylene, but the second resin layer 12 and the third resin layer contain polypropylene, and the content of polypropylene in the polymer film 10 is preferably 70 mass% or more, more preferably 80 mass% or more, and still more preferably 90 mass% or more. Thus, the recyclability of the polymer film can be improved.

The third resin layer 13 may contain a resin material other than polypropylene as long as the characteristics of the present disclosure are not impaired. Examples of the resin material other than polypropylene include polyolefins such as polyethylene, (meth)acrylic resins, vinyl resins, cellulose resins, polyamide resins, polyesters, ionomer resins, and the like.

The third resin layer 13 can contain an additive as long as the characteristics of the present disclosure are not impaired. Examples of the additive include crosslinking agents, antioxidants, anti-blocking agents, lubricants, ultraviolet absorbents, light stabilizers, fillers, reinforcing agents, antistatic agents, pigments, and modifying resins as compatibilizers.

The thickness of the third resin layer 13 is preferably 10 µm or more, and more preferably 15 µm or more. Thus, the strength and heat resistance of the polymer film 10 can be further improved. The thickness of the third resin layer 13 is preferably 50 µm or less, more preferably 40 µm or less, and still more preferably 30 µm or less. This makes it possible to further improve the film-forming properties, processability, and productivity of the polymer film 10.

For example, the thickness of the third resin layer 13 is preferably 10 µm or more and 50 µm or less, more preferably 15 µm or more and 40 µm or less, and still more preferably 15 µm or more and 30 µm or less.

### (Second resin layer)

The second resin layer 12 contains an acid-modified product of polypropylene. The acid-modified product of polypropylene is a resin having excellent adhesion properties; thus, the polyamide contained in the first resin layer 11 and the polypropylene in the third resin layer can be bonded to each other, and the interlayer adhesion between the first resin layer 11 and the third resin layer 13 can be improved. In addition, since the acid-modified product of polypropylene is a polypropylene-based resin similarly to homopolypropylene which is a constituent material of the third resin layer 13, by adopting the acid-modified product of polypropylene as the resin constituting the second resin layer 12, the recyclability of the polymer film 10 can be improved.

The acid-modified product of polypropylene is obtained by graft-polymerizing an unsaturated compound having one or more carboxylic acid groups, an ester of an unsaturated carboxylic acid compound having a carboxylic acid group and an alkyl alcohol, or an unsaturated compound having one or more carboxylic anhydride groups to polypropylene. The ratio of graft polymerization is preferably 1 mol% or more and 2 mol% or less. More preferably, the ratio of graft polymerization is 1 mol% or more and 2 mol% or less, and the polymer film 10 is an oriented film.

Examples of the unsaturated group include a vinyl group, a vinylene group, and an unsaturated cyclic hydrocarbon group. The unsaturated compound having a carboxylic acid group may be used alone or in combination of two or more types thereof. Examples thereof include unsaturated carboxylic acids such as acrylic acid, methacrylic acid, maleic acid, fumaric acid, tetrahydrophthalic acid, itaconic acid, citraconic acid, crotonic acid, nadic acid, and endo-cis-bicyclo[2,2,1]hept-5-ene-2,3-dicarboxylic acid. As the unsaturated compound having one or more carboxylic anhydride groups, maleic anhydride is suitable.

In the acid-modified product of polypropylene, the polypropylene to be acid-modified is homopolypropylene, a polypropylene random copolymer or a polypropylene block copolymer, and a plurality of these may be used. In addition, such acid-modified products may be mixed. In particular, a polypropylene random copolymer is preferably used as a main component. The polypropylene random copolymer is a random copolymer of propylene and an olefin other than propylene. The polypropylene block copolymer is a copolymer having a polymer block composed of propylene and a polymer block composed of the above-described olefin other than propylene.

As the acid-modified product of polypropylene, commercially available products can be used. For example, ADMER series manufactured by Mitsui Chemicals, Inc. or Modic series manufactured by Mitsubishi Chemical Corporation can be used.

The thickness of the second resin layer 12 is preferably 0.2 µm or more, and more preferably 0.5 µm or more. Thus, the adhesion between the first resin layer 11 and the third resin layer 13 can be further improved. The thickness of the second resin layer 12 is preferably 15 µm or less, more preferably 5 µm or less, and still more preferably 2 µm or less. Thus, the processability of the polymer film 10 can be improved.

For example, the thickness of the second resin layer 12 is preferably 0.2 µm or more and 15 µm or less, more preferably 0.5 µm or more and 5 µm or less, and still more preferably 0.5 µm or more and 2 µm or less.

The ratio of the thickness of the second resin layer 12 to the total thickness of the polymer film 10 is preferably 1% or more, and more preferably 2.5% or more. Thus, the adhesion between the first resin layer 11 and the third resin layer 13 can be improved. In addition, the ratio of the thickness of the second resin layer 12 to the total thickness of the polymer film 10 is preferably 20% or less, and more preferably 10% or less. Thus, the processability can be improved, and the cost can be reduced.

For example, the ratio of the thickness of the second resin layer 12 to the total thickness of the polymer film 10 is preferably 1% or more and 20% or less, and more preferably 2.5% or more and 10% or less.

The second resin layer 12 contains an acid-modified product of polypropylene, but a layer containing an acid-modified product of polypropylene may be provided on the first resin layer 11 side, and a layer containing, as a main component, a polypropylene random copolymer containing no acid-modified product may be provided on the third resin layer 13 side. The layer on the first resin layer 11 side contains the acid-modified product as a main component to enhance adhesion to the first resin layer 11, and the layer containing no acid-modified product is provided on the third resin layer 13 side and bonded to the third resin layer 13. As a result, the amount of the acid-modified product to be used can be reduced and the cost can be reduced. The thickness of the second resin layer 12 can be set to 0.2 µm or more and 15 µm or less as a whole by setting the thickness of the layer containing an acid-modified product of polypropylene as a main component to 0.1 µm or more and 5 µm or less and the thickness of the layer of polypropylene containing no acid-modified product to 0.1 µm or more and 14.9 µm or less.

### (Fourth resin layer)

As shown in Fig. 2, the polymer film 10 can include a fourth resin layer 14 on a side of the third resin layer 13 opposite the second resin layer 12. The fourth resin layer 14 includes a copolymer of propylene and an olefin other than propylene. Examples of the copolymer of propylene and an olefin other than propylene include a polypropylene random copolymer. The polypropylene random copolymer is a random copolymer of propylene and an olefin other than propylene (for example, ethylene, 1-butene, 1-pentene, 4-methyl-1-pentene, 1-hexene, or 1-octene). Examples of the random copolymer include an ethylene-propylene random copolymer and an ethylene-1-butene-propylene random copolymer. The fourth resin layer 14 may include, in addition to the copolymer of propylene and an olefin other than propylene, one or more selected from the group consisting of homopolypropylene, a polypropylene block copolymer and polyethylene. Among these, it is preferable to further include polyethylene, and it is more preferable to further include high-density polyethylene. The fourth resin layer 14 contains the copolymer of propylene and an olefin other than propylene in an amount of preferably 51 mass% or more, more preferably 60 mass% or more, further preferably 70 mass% or more, and still further preferably 95 mass% or more. Thus, sufficient impact strength can be obtained. The upper limit value of the content of the copolymer of propylene and an olefin other than propylene in the fourth resin layer 14 is 100 mass%, and particularly preferably substantially 100 mass%. For example, the content of the copolymer of propylene and an olefin other than propylene in the fourth resin layer 14 is preferably 51 mass% or more and 100 mass% or less, more preferably 60 mass% or more and 100 mass% or less, still more preferably 70 mass% or more and 100 mass% or less, further more preferably 95 mass% or more and 100 mass% or less.

The thickness of the fourth resin layer 14 is preferably 0.2 µm or more, and more preferably 0.4 µm or more. As a result, the drop impact strength described below can be increased. In addition, the thickness of the fourth resin layer 14 is preferably 15 µm or less, more preferably 5 µm or less, and still more preferably 2 µm or less. Thus, the processability of the polymer film 10 can be improved.

For example, the thickness of the fourth resin layer 14 is preferably 0.2 µm or more and 15 µm or less, more preferably 0.4 µm or more and 5 µm or less, and still more preferably 0.4 µm or more and 2 µm or less.

The ratio of the thickness of the fourth resin layer 14 to the total thickness of the polymer film 10 is preferably 1% or more, and more preferably 2% or more. Thus, the drop impact strength can be increased. In addition, the ratio of the thickness of the fourth resin layer 14 to the total thickness of the polymer film 10 is preferably 20% or less, and more preferably 10% or less. Thus, the processability can be improved, and sufficient rigidity can be imparted to the polymer film 10.

For example, the ratio of the thickness of the fourth resin layer 14 to the total thickness of the polymer film 10 is preferably 1% or more and 20% or less, and more preferably 2% or more and 10% or less.

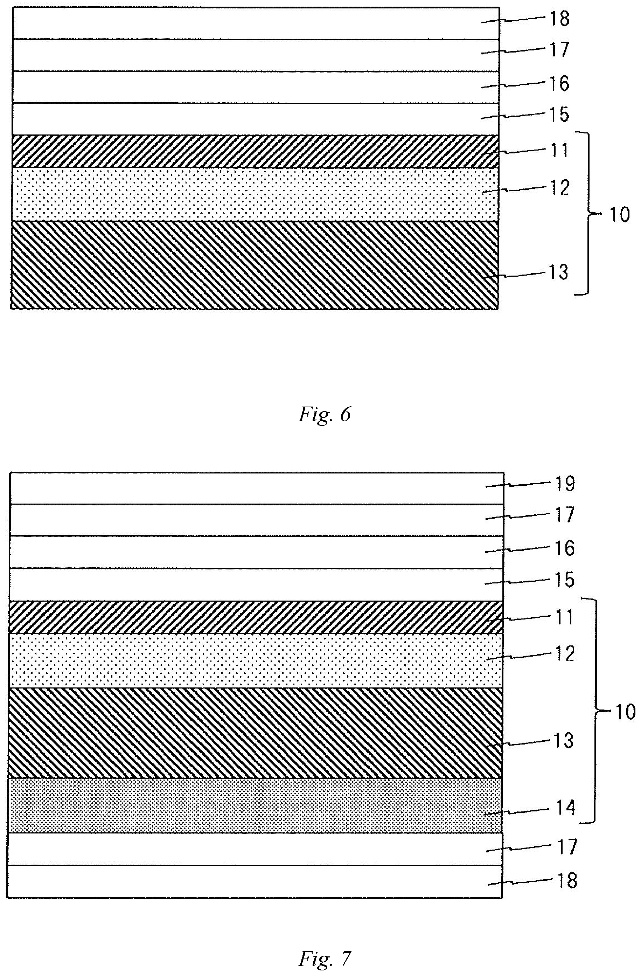

As shown in Fig. 6, the polymer film 10 not provided with the fourth resin layer 14 is formed into a laminate by laminating a heat sealable heat sealant film 18 containing another polypropylene on the vapor deposition film 15 side. The heat sealant film 18 of the obtained laminate is thermally fused to form a packaging bag, which is filled with contents and sealed.

A laminate having a configuration in which the polymer film 10 including the vapor deposition film 15 and not including the fourth resin layer 14 is sandwiched between other two films can also be considered. In this case, a polypropylene base film 19 containing polypropylene is laminated on the side of the vapor deposition film 15, and a heat sealant film 18 containing polypropylene is laminated on the side of the third resin layer 13 to form a laminate. The heat sealant film 18 is thermally fused to form a packaging bag, which is filled with contents and sealed. This packaging bag may be broken due to drop impact.

As shown in Fig. 7, it is also possible to laminate a polypropylene base film 19 containing polypropylene on the vapor deposition film 15 side of the barrier film having the vapor deposition film 15 on the first resin layer 11 side of the polymer film 10 provided with the fourth resin layer 14, and laminate a heat sealant film 18 containing polypropylene on the third resin layer 13 side to obtain a laminate in which the three types of films are laminated. By using this laminate as a packaging material, it is possible to prevent bag breakage due to drop impact of a packaging bag to be produced.

In the case where the third resin layer 13 contains homopolypropylene as a main component, if the crystallinity of the homopolymer is high and the homopolymer is crystallized in layers, the homopolypropylene may undergo cohesive failure between the crystals in layers due to impact. It is considered that polypropylene random copolymers have low crystallinity, the polymers are entangled, and cohesive failure due to impact is less likely to occur.

The content of polypropylene in the polymer film 10 including the fourth resin layer 14 is preferably 70 mass% or more, more preferably 80 mass% or more, and still more preferably 90 mass% or more. The content of polypropylene in the polymer film 10 not including the fourth resin layer 14 is also preferably 70 mass% or more, more preferably 80 mass% or more, and further preferably 90 mass% or more. Thus, the recyclability of the polymer film can be improved. The polypropylene may be any of homopolypropylene, polypropylene random copolymers, polypropylene block copolymers, and acid-modified products of these polypropylenes.

### (Production of polymer film 10)

The polymer film 10 is preferably a film subjected to a stretching treatment. The stretching treatment may be uniaxial stretching or biaxial stretching. That is, the polymer film 10 may be a uniaxially oriented film or a biaxially oriented film. The polymer film 10 subjected to the biaxial stretching treatment can be produced by, for example, forming at least the first resin layer 11, the second resin layer 12, and the third resin layer 13 into a sheet shape by multilayer coextrusion, and stretching the extruded sheet in the machine direction (MD direction) and the transverse direction (TD direction). In the case of the polymer film 10 further including the fourth resin layer 14, the first resin layer 11, the second resin layer 12, the third resin layer 13, and the fourth resin layer 14 may be formed into a sheet shape by multilayer coextrusion, and the extruded sheet may be stretched in the machine direction and the transverse direction. Stretching in both directions is biaxial stretching, and stretching only in the machine direction or the transverse direction is uniaxial stretching. Of these, biaxial stretching is preferable. The stretch ratio is preferably 2 times or more, more preferably 3 times or more, and still more preferably 5 times or more in both the machine direction and the transverse direction. Thus, the strength and heat resistance of the polymer film 10 can be further improved. In addition, from the viewpoint of the breaking limit of the polypropylene film, the stretch ratio is preferably 15 times or less, more preferably 13 times or less, and even more preferably 10 times or less in both the machine direction and the transverse direction. The stretch ratio in the transverse direction is preferably larger than the stretch ratio in the machine direction. For example, the stretch ratio in the machine direction may be 3 times or more and 6 times or less, and the stretch ratio in the transverse direction may be 8 times or more and 13 times or less.

Biaxial stretching, which is a type of stretching treatment, may be simultaneous stretching in which stretching is performed simultaneously in the machine direction and the transverse direction, or may be sequential stretching in which stretching is performed in the machine direction and then in the transverse direction. That is, the polymer film 10 may be a simultaneously biaxially oriented film or a sequentially biaxially oriented film. The polymer film 10 is preferably a sequentially biaxially oriented film because the polymer film 10 can be produced by a simple apparatus, so that the polymer film 10 can be produced at low cost, and is also excellent in productivity.

For each resin layer, the same or different resins may be extruded from a plurality of extruders and joined together. The first resin layer 11 may have a multilayer structure in which different polyamide resins are extruded as layers by a plurality of extruders. In the entire first resin layer 11 having a multilayer structure, the ratio of the number of diamine units contained in the aromatic polyamide to the total number of aminocarboxylic acid units and diamine units contained in the polyamide resin constituting the first resin layer and the ratio of the number of aromatic diamine units contained in the aromatic polyamide to the total number of aminocarboxylic acid units and diamine units contained in the polyamide resin constituting the first resin layer are at least within the certain ranges.

The biaxial stretching method may be a method in which at least the first resin layer 11, the second resin layer 12, and the third resin layer 13 are formed into a tubular film by multilayer coextrusion, the formed tube is stretched in the MD direction while being heated, and at the same time, air is supplied into the tube to stretch the tube in the TD direction.

The third resin layer 13 may be extruded, the obtained sheet may be stretched in the machine direction, the first resin layer 11 and the second resin layer 12 may be coextruded and laminated on the uniaxially stretched third resin layer 13, and then the third resin layer 13 may be stretched in the transverse direction. As a result, the extrusion device can be simplified and the amount of work required for maintenance can be reduced. In addition, by making the widths of the first resin layer 11 and the second resin layer to be laminated on the third resin layer 13 narrower than the width of the third resin layer 13, it is possible to prevent the first resin layer 11 from being included in portions to be chucked at the time of transverse stretching and to prevent polyamide from being included in a recycle material for recycling the chucked portions, and thus recyclability of the recycle material can be enhanced.

The stretching treatment is preferably performed so that the tensile strength in the transverse direction (TD direction) of the polymer film 10 is larger than the tensile strength in the machine direction (MD direction). As a result of such a configuration, high tearability in one direction can be imparted to a packaging bag produced using the barrier film of the present disclosure. The tensile strength in the transverse direction (TD direction) of the polymer film 10 is preferably 1.05 times or more, more preferably 1.10 times or more, and still more preferably 1.2 times or more the tensile strength in the machine direction (MD direction). The tensile strength in the transverse direction (TD direction) can be, for example, 200 MPa or more and 300 MPa or less.

In the present specification, the tensile strength of the polymer film 10 is measured in accordance with JIS K7127:1999. As a measuring device, a tensile tester STA-1150 manufactured by ORIENTEC CORPORATION can be used. As the test piece, a piece obtained by cutting the polymer film 10 into a rectangular film having a width of 15 mm and a length of 150 mm can be used. The distance between a pair of chucks holding the test piece at the start of measurement is 100 mm, and the tensile speed is 300 mm/min. In the present specification, unless otherwise specified, the environment at the time of measuring the tensile strength has a temperature of 23°C and a relative humidity of 50%.

The thickness of the polymer film 10 is preferably 10 µm or more. Thus, the strength of the polymer film 10 is improved, and the polymer film 10 is less likely to be broken during processing. Further, the thickness of the polymer film 10 is preferably 50 µm or less. As a result, when the polymer film 10 is used as a packaging material, it is possible to prevent the strength from becoming excessively higher than the required strength and to prevent waste of resources.

For example, the thickness of the polymer film 10 is preferably 10 µm or more and 50 µm or less.

In the polymer film 10, it is preferable that the thickness of the third resin layer 13 is the largest among the thicknesses of the first resin layer 11, the second resin layer 12, and the third resin layer 13, and the thicknesses of layers constituting the polymer film 10 satisfy the following formulae (1) and (2). $Thickness of first resin layer 11 \leq \left(Thickness of polymer film 10\right) / 10$ (1) $Thickness of second resin layer 12 \leq \left(Thickness of polymer film 10\right) / 5$ (2)

Since the third resin layer 13 containing homopolypropylene is the main body of the polymer film 10 and the third resin layer 13 is a layer that determines the physical properties of the polymer film 10, the thickness of the third resin layer 13 is preferably the largest.

The polyamide resin contained in the first resin layer 11 is a resin different from polypropylene, and a large amount of the polyamide resin contained in the polymer film 10 may hinder recycling; therefore, it is preferable to reduce the amount of the polyamide resin used. Therefore, the thickness of the first resin layer 11 is preferably 1/10 or less of the thickness of the polymer film 10, and more preferably 1/13.3 or less of the thickness of the polymer film 10.

The acid-modified product of polypropylene contained in the second resin layer 12 is a polypropylene-based resin and does not hinder recycling. However, since the cost is relatively high, the amount of the acid-modified product of polypropylene to be used is preferably small as long as the first resin layer 11 and the third resin layer 13 can be sufficiently bonded to each other and the stress of the expansion and contraction of the third resin layer 13 can be absorbed. Therefore, the thickness of the second resin layer 12 is preferably 1/5 or less of the thickness of the polymer film 10.

In the polymer film 10, the thickness of the first resin layer 11 constituting the polymer film 10 more preferably satisfies the following formula (3), and further preferably satisfies the following formula (4). $\left(Thickness of polymer film 10\right) / 100 \leq Thickness of first resin layer 11$ (3) $\left(Thickness of polymer film 10\right) / 50 \leq Thickness of first resin layer 11$ (4)

When the thickness of the first resin layer 11 is equal to or greater than the lower limit value, the gas barrier properties of the polymer film 10 can be improved due to the high gas barrier properties of the first resin layer 11, and in addition, the adhesion to the vapor deposition film 15 can be increased, and the gas barrier properties can be further improved.

Further, in the polymer film 10, the thickness of the first resin layer 11 constituting the polymer film 10 preferably satisfies the following (5), and more preferably satisfies the following formula (6). 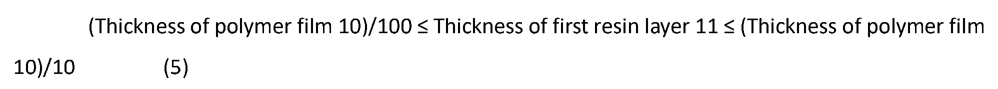 (Thickness of polymer film 10)/100 ≤ Thickness of first resin layer 11 ≤ (Thickness of polymer film 10)/10 (5) 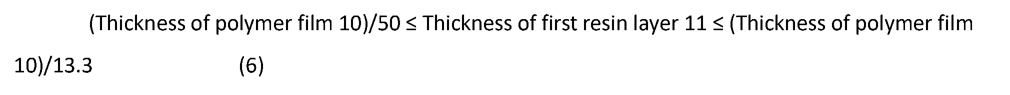 (Thickness of polymer film 10)/50 ≤ Thickness of first resin layer 11 ≤ (Thickness of polymer film 10)/13.3 (6)

In the polymer film 10, the thickness of the second resin layer 12 constituting the polymer film 10 more preferably satisfies the following formula (7). $\left(Thickness of polymer film 10\right) / 100 \leq Thickness of second resin layer 12$ (7)

When the thickness of the second resin layer 12 is equal to or greater than the lower limit value, the adhesion between the first resin layer 11 and the third resin layer 13 can be improved.

In addition, in the polymer film 10, the thickness of the second resin layer 12 constituting the polymer film 10 preferably satisfies the following (8). 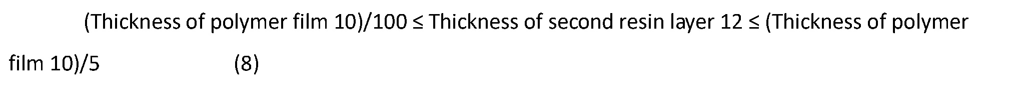 (Thickness of polymer film 10)/100 ≤ Thickness of second resin layer 12 ≤ (Thickness of polymer film 10)/5 (8)

### (Vapor deposition film 15)

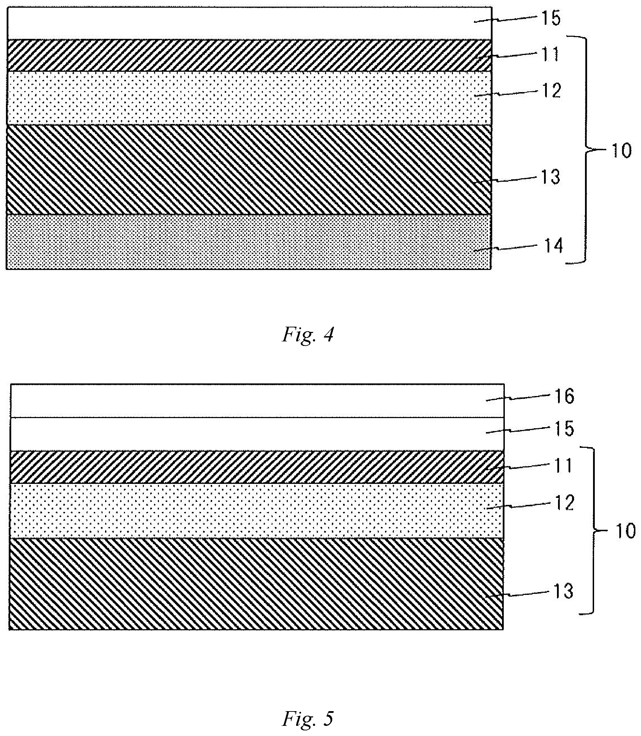

As shown in Fig. 3, the barrier film of the present disclosure includes the vapor deposition film 15 containing an inorganic oxide on the first resin layer 11 side of the polymer film 10. In addition, in the barrier film of the present disclosure, in a case where the polymer film 10 includes the fourth resin layer 14, as shown in Fig. 4, the vapor deposition film 15 containing an inorganic oxide is provided on the first resin layer 11 side. The vapor deposition film 15 may be formed on the surface of the first resin layer 11. Another layer may be provided between the first resin layer 11 and the vapor deposition film 15. By forming the vapor deposition film 15, gas barrier properties, specifically, oxygen barrier properties and water vapor barrier properties can be imparted to the barrier film. In addition, it is possible to suppress alteration of the contents and influence on the atmosphere such as the deterioration of the quality of the contents packaged by the packaging bag including the laminate prepared using the barrier film of the present disclosure due to oxidation, the deterioration of the contents due to evaporation of water vapor or moisture absorption, a decrease in the commercial value due to volatilization of the aroma component of the contents, the influence on the environment due to volatilization of the aroma component, and the like.

When a packaging bag made of a laminate including a barrier film having a vapor deposition film made of aluminum is subjected to retort treatment, the aluminum vapor deposition film is dissolved from an end surface, and a dissolved portion of the aluminum vapor deposition film is peeled off. In particular, in a shower retort where hot water is sprayed onto the article to be sterilized, this phenomenon occurs noticeably. In the dissolved portion of the aluminum vapor deposition film, the adhesion strength between the polymer film and the vapor deposition film decreases, the aluminum vapor deposition film peels off from the polymer film, and the gas barrier properties deteriorate. In order to prevent such a problem from occurring, in the barrier film of the present disclosure, the vapor deposition film 15 contains an inorganic oxide, preferably contains an inorganic oxide as a main component, and is more preferably made of an inorganic oxide.

Examples of the inorganic oxide include aluminum oxide (alumina), silicon oxide (silica), magnesium oxide, calcium oxide, zirconium oxide, titanium oxide, boron oxide, hafnium oxide, barium oxide and carbon-containing silicon oxide. Among these, silicon oxide, carbon-containing silicon oxide, and aluminum oxide are preferable.

The aluminum oxide may include aluminum hydroxide oxide AlO_{y}(OH)_{z} (where y and z represent numbers satisfying 0 ≤ y ≤ 1.5, 0 ≤ z ≤ 3, and 2y + z = 3) and aluminum hydroxide Al(OH)₃ in addition to an aluminum oxide AlOₓ (where x represents a number of 0 or more and 1.5 or less).

The inorganic oxide is more preferably carbon-containing silicon oxide because a decrease in gas barrier properties can be suppressed even after the barrier film is bent.

The thickness of the vapor deposition film 15 is preferably 3 nm or more, more preferably 5 nm or more, and still more preferably 8 nm or more. Thus, the oxygen barrier properties and the water vapor barrier properties of the barrier film can be further improved. The thickness of the vapor deposition film 15 is preferably 150 nm or less, more preferably 60 nm or less, and still more preferably 40 nm or less. Thus, the occurrence of cracks in the vapor deposition film 15 can be prevented. In addition, when the thickness of the vapor deposition film 15 is within the above range, the recyclability is not impaired when the barrier film is used as a constituent film of a packaging material.

For example, the thickness of the vapor deposition film 15 is preferably 3 nm or more and 150 nm or less, more preferably 5 nm or more and 60 nm or less, and still more preferably 8 nm or more and 40 nm or less.

The vapor deposition film 15 can be formed by a conventionally known method. Examples of the method for forming the vapor deposition film 15 include physical vapor deposition methods (Physical Vapor Deposition methods or PVD methods) such as a vacuum vapor deposition method, a sputtering method, and an ion-plating method, and chemical vapor deposition methods (Chemical Vapor Deposition methods or CVD methods) such as a plasma chemical vapor deposition method, a thermal chemical vapor deposition method, and a photochemical vapor deposition method.

The vapor deposition film 15 may be a single layer formed by a single vapor deposition step or a multilayer formed by a plurality of vapor deposition steps. In the case of the multilayer, the layers may be formed of the same material or different materials. The respective layers may be formed by the same method or different methods.

The vapor deposition film 15 may be formed, and a layer containing an organic substance such as a barrier coat layer 16 described later may be provided on the outer surface of the vapor deposition film 15. Thus, high barrier properties can be obtained. Further, stacking of a vapor deposition film and a layer containing an organic substance may be repeated; for example, a vapor deposition film may be further provided on the surface of the layer containing an organic substance, and a layer containing an organic substance may be further provided on the outer surface of the vapor deposition film.

A plasma-assisted vacuum deposition apparatus can be used as an apparatus used in a method for forming a vapor deposition film by a PVD method. Details of this formation method are disclosed in Japanese Unexamined Patent Application Publication No. 2011-214089.

As a plasma generator used in the plasma chemical vapor deposition method, a generator of high-frequency plasma, pulse wave plasma, microwave plasma, or the like can be used. Further, an apparatus having two or more film formation chambers may be used. Details of this formation method are disclosed in Japanese Unexamined Patent Application Publication No. 2012-076292.

As an apparatus used for the method of forming the vapor deposition film 15, a continuous vapor deposition film forming apparatus including a plasma pretreatment chamber and a film formation chamber can be used. In the plasma pretreatment chamber, the first resin layer 11 included in the polymer film 10 is irradiated with plasma from the plasma supply nozzle. Next, in the film formation chamber, the vapor deposition film 15 is formed on the plasma-treated first resin layer 11. Details of this formation method are disclosed in International Publication No. 2019/087960.

The surface of the vapor deposition film 15 is preferably subjected to plasma treatment. This can improve the adhesion to the barrier coat layer 16 described later and provided on the surface of the vapor deposition film 15.

In the barrier film of the present disclosure, when the vapor deposition film 15 is a carbon-containing silicon oxide vapor deposition film, a decrease in gas barrier properties can be suppressed even after the barrier film is bent. The carbon-containing silicon oxide vapor deposition film can be formed by a CVD method.

The carbon-containing silicon oxide vapor deposition film contains silicon, oxygen, and carbon. In the carbon-containing silicon oxide vapor deposition film, the ratio of carbon is preferably 3% or more, more preferably 5% or more, and still more preferably 10% or more with respect to 100% of the total of the three elements of silicon, oxygen, and carbon. In the carbon-containing silicon oxide vapor deposition film, the ratio of carbon is preferably 50% or less, more preferably 40% or less, and still more preferably 35% or less with respect to 100% of the total of the three elements of silicon, oxygen, and carbon. For example, in the carbon-containing silicon oxide vapor deposition film, the ratio of carbon is preferably 3% or more and 50% or less, more preferably 5% or more and 40% or less, and still more preferably 10% or more and 35% or less with respect to 100% of the total of the three elements of silicon, oxygen, and carbon. In the carbon-containing silicon oxide vapor deposition film, when the ratio of carbon is in the above range, a decrease in gas barrier properties can be suppressed even after the barrier film is bent.

It is preferable that the ratio of carbon is 3% or more and 50% or less, the ratio of oxygen is 30% or more and 65% or less, and the ratio of silicon is 25% or more and 40% or less with respect to 100% of the total of the three elements of carbon, oxygen, and silicon. When the ratio of carbon is 3% or more, a decrease in gas barrier properties can be further suppressed even after the barrier film is bent. When the ratio of carbon is 50% or less, the tint of the appearance can be suppressed.

### (Measurement of ratios of elements of carbon-containing silicon oxide vapor deposition film)

The ratios of carbon, silicon, and oxygen in the carbon-containing silicon oxide vapor deposition film can be measured by X-ray photoelectron spectroscopy (XPS) described below.

A narrow spectrum of each element at the surface of the carbon-containing silicon oxide vapor deposition film is measured using an X-ray photoelectron spectrometer (XPS). Thereafter, the surface after measurement is etched under the conditions described later to expose a new measurement surface. A narrow spectrum of each element is measured at the exposed measurement surface under the same conditions.

For each of the narrow spectra of C1s, O1s, and Si2p, the background is subtracted by the Shirley method using analysis software to obtain the integrated intensity (area) of the peak of each element. The ratio of each element (element%) is calculated using the obtained integrated intensity (area). To reduce the effect of surface contamination, the ratio of each element after a single 30-second etching is used.

### <X-ray photoelectron spectrum measurement conditions>

Device: ESCA3400 manufactured by SHIMADZU CORPORATION
X-ray source: MgKα
Emission current: 20 mA
Acceleration voltage: 10 kV
Resolution: Low
Measurement region: about 6 mmϕ

### <Etching conditions>

Ion species: Ar⁺
Pressure of Ar gas introduction: 2.0 × 10⁻² Pa
Emission current: 30 mA
Acceleration voltage: 0.3 kV
Etching time: 30 seconds × 1 time

### (Barrier coat layer 16)

In one embodiment of the barrier film of the present disclosure, as shown in Fig. 5, the barrier coat layer 16 may be provided on the vapor deposition film 15. By forming the barrier coat layer 16 on the surface of the vapor deposition film 15, the oxygen barrier properties and the water vapor barrier properties of the barrier film are further improved.

In one embodiment of the barrier film of the present disclosure, although not shown, when the polymer film 10 includes the fourth resin layer 14, the barrier coat layer 16 may be provided on the vapor deposition film 15. By forming the barrier coat layer 16 on the surface of the vapor deposition film 15, the oxygen barrier properties and the water vapor barrier properties of the barrier film are further improved.

The barrier coat layer 16 contains a gas barrier resin such as an ethylene-vinyl alcohol copolymer (EVOH), polyvinyl alcohol (PVA), polyester, polyurethane, or a (meth)acrylic resin. Among these, polyvinyl alcohol is preferable from the viewpoint of improving oxygen barrier properties and water vapor barrier properties. By incorporating polyvinyl alcohol into the barrier coat layer 16, the occurrence of cracks in the vapor deposition film 15 can be effectively prevented.

The content of the gas barrier resin in the barrier coat layer 16 is preferably 50 mass% or more, and more preferably 75 mass% or more. Thus, the oxygen barrier properties and the water vapor barrier properties can be further improved. The content of the gas barrier resin in the barrier coat layer 16 is 100 mass% or less, preferably 95 mass% or less, more preferably 90 mass% or less.

For example, the content of the gas barrier resin in the barrier coat layer 16 is preferably 50 mass% or more and 100 mass% or less, more preferably 50 mass% or more and 95 mass% or less, and still more preferably 75 mass% or more and 90 mass% or less.

The thickness of the barrier coat layer 16 is preferably 0.01 µm or more, more preferably 0.1 µm or more, and still more preferably 0.2 µm or more. Thus, the oxygen barrier properties and the water vapor barrier properties of the barrier film can be further improved. The thickness of the barrier coat layer 16 is preferably 10 µm or less, more preferably 5 µm or less, and still more preferably 1 µm or less. Thus, the processability of the barrier film can be improved. In addition, when the thickness of the barrier coat layer 16 is within the above range, the recyclability is not impaired even when the barrier coat layer 16 is made of a material different from polypropylene.

For example, the thickness of the barrier coat layer 16 is preferably 0.01 µm or more and 10 µm or less, more preferably 0.1 µm or more and 5 µm or less, and still more preferably 0.2 µm or more and 1 µm or less.

The barrier coat layer 16 can be formed by dissolving or dispersing the above-mentioned gas barrier resin in water or an appropriate solvent, followed by coating and drying.

The barrier coat layer 16 is preferably a gas barrier coating film containing at least one resin composition such as a hydrolysate of a metal alkoxide or a hydrolysis-condensation product of a metal alkoxide obtained by polycondensation of a mixture of a metal alkoxide and a water-soluble polymer by a sol-gel method in the presence of a sol-gel catalyst, water, an organic solvent, and the like. The gas barrier coating film is a gas barrier coating film of a mixture of a metal alkoxide and a water-soluble polymer, or a gas barrier coating film of a mixture of a metal alkoxide, a water-soluble polymer and a silane coupling agent. By providing such a barrier coat layer 16 on the vapor deposition film 15, the occurrence of cracks in the vapor deposition film 15 can be effectively prevented.

The metal alkoxide is represented by the following general formula.

R¹ₙM(OR²)ₘ

In the formula, R¹ and R² each represent an organic group having 1 or more and 8 or less carbon atoms, M represents a metal atom, n represents an integer of 0 or more, m represents an integer of 1 or more, and n + m represents the valence of M.

As the metal atom M, for example, silicon, zirconium, titanium, aluminum, or the like can be used. Examples of the organic groups represented by R¹ and R² include alkyl groups such as a methyl group, an ethyl group, an n-propyl group, an i-propyl group, an n-butyl group, and an i-butyl group.

Examples of the metal alkoxide satisfying the above general formula include tetramethoxysilane (Si(OCH₃)₄), tetraethoxysilane (Si(OC₂H₅)₄), tetrapropoxysilane (Si(OC₃H₇)₄), and tetrabutoxysilane (Si(OC₄H₉)₄).

A silane coupling agent may be used together with the metal alkoxide. As the silane coupling agent, known organoalkoxysilanes containing an organic reactive group can be used, and examples thereof include vinyltrimethoxysilane, γ-chloropropylmethyldimethoxysilane, γ-chloropropyltrimethoxysilane, 3-glycidoxypropylmethyldimethoxysilane, 3-glycidoxypropyltrimethoxysilane, 3-glycidoxypropylmethyldiethoxysilane, 3-glycidoxypropylmethyltriethoxysilane, γ-methacryloxypropyltrimethoxysilane, γ-methacryloxypropylmethyldimethoxysilane, 1,3,5-tris(3-methoxysilylpropyl)isocyanurate and the like.

Two or more types of silane coupling agents may be used, and a silane coupling agent is preferably used within a range of 1 part by mass or more and 20 parts by mass or less with respect to 100 parts by mass of the total amount of the metal alkoxide.

As the water-soluble polymer, polyvinyl alcohol and an ethylene-vinyl alcohol copolymer are preferable, and from the viewpoint of oxygen barrier properties, water vapor barrier properties, water resistance and weather resistance, it is preferable to use these in combination.

The degree of polymerization of the polyvinyl alcohol is preferably 300 or more. Thus, a decrease in gas barrier properties due to bending can be suppressed. The degree of polymerization of the polyvinyl alcohol is preferably 3000 or less. Thus, difficulty in processing can be suppressed.

For example, the degree of polymerization of the polyvinyl alcohol is preferably 300 or more and 3000 or less.

The saponification degree of the polyvinyl alcohol is preferably 90 mol% or more, more preferably 95 mol% or more, and still more preferably 99 mol% or more.

The degree of polymerization of the ethylene-vinyl alcohol copolymer is preferably 300 or more. Thus, a decrease in gas barrier properties due to bending can be suppressed. The degree of polymerization of the ethylene-vinyl alcohol copolymer is preferably 3000 or less. Thus, difficulty in processing can be suppressed.

For example, the degree of polymerization of the ethylene-vinyl alcohol copolymer is preferably 300 or more and 3000 or less.

The saponification degree of the ethylene-vinyl alcohol copolymer is preferably 90 mol% or more, more preferably 95 mol% or more, and still more preferably 99 mol% or more.

The content of the ethylene unit in the ethylene-vinyl alcohol copolymer is preferably 10 mol% or more, more preferably 15 mol% or more, still more preferably 20 mol% or more, and particularly preferably 25 mol% or more. The content of the ethylene unit in the ethylene-vinyl alcohol copolymer is preferably 65 mol% or less, more preferably 55 mol% or less, and still more preferably 50 mol% or less. For example, the content of the ethylene unit in the ethylene-vinyl alcohol copolymer is preferably 10 mol% or more and 65 mol% or less, more preferably 15 mol% or more and 55 mol% or less, further preferably 20 mol% or more and 50 mol% or less, and still further preferably 25 mol% or more and 50 mol% or less. Ethylene-vinyl alcohol copolymers having different ethylene contents may be mixed.

The thickness of the gas barrier coating film is preferably 0.01 µm or more, and more preferably 0.1 µm or more. Thus, the oxygen barrier properties and the water vapor barrier properties of the barrier film can be improved, and the occurrence of cracks in the vapor deposition film can be prevented. The thickness of the gas barrier coating film is preferably 1 µm or less, and more preferably 0.5 µm or less. This makes it possible to suppress the occurrence of cracks in the gas barrier coating film itself while maintaining the recyclability.

For example, the thickness of the gas barrier coating film is preferably 0.01 µm or more and 1 µm or less, and more preferably 0.1 µm or more and 0.5 µm or less.

The gas barrier coating film can be formed by applying a composition containing the above-mentioned materials by a conventionally known means such as roll coating using a gravure roll coater or the like, spray coating, spin coating, dipping, brushing, bar coating, or an applicator, and polycondensing the composition by a sol-gel method. As the sol-gel method catalyst, an acid or an amine-based compound is suitable.

The composition may contain an organic solvent. As the organic solvent, for example, methyl alcohol, ethyl alcohol, n-propyl alcohol, isopropyl alcohol, n-butanol, or the like can be used.

A method for forming the gas barrier coating film will be described below. A metal alkoxide, a water-soluble polymer, a sol-gel method catalyst, water, an organic solvent, and if necessary, a silane coupling agent and the like are mixed to prepare a composition. The polycondensation reaction gradually proceeds in the composition. Next, the composition is applied onto the vapor deposition film 15 by the above-mentioned conventionally known method and dried. By the drying, the polycondensation reaction of the metal alkoxide, the water-soluble polymer, and the silane coupling agent in the case where the composition contains the silane coupling agent proceeds, and a layer of the composite polymer is formed. The heating temperature during drying is preferably 20°C or higher, more preferably 50°C or higher, and even more preferably 80°C or higher, and is preferably 250°C or lower, more preferably 200°C or lower, and even more preferably 150°C or lower. For example, the heating temperature during drying is preferably 20°C or higher and 250°C or lower, more preferably 50°C or higher and 200°C or lower, and still more preferably 80°C or higher and 150°C or lower. The drying time is preferably 1 second or more and 10 minutes or less.

A printed layer may be formed on the surface of the barrier coat layer 16.

### (Laminate)

In the barrier film of the present disclosure, the barrier coat layer 16 is provided on the surface of the vapor deposition film 15, and the barrier film is laminated with another film to form a laminate. As shown in Fig. 5, the barrier coat layer 16 is provided on the surface of the vapor deposition film 15 of the barrier film in which the vapor deposition film 15 is provided on the first resin layer side of the polymer film 10 having the first resin layer 11, the second resin layer 12, and the third resin layer 13. The surface of the vapor deposition film 15 may be laminated with another film without being provided with the barrier coat layer 16.

In the barrier film of the present disclosure, the barrier coat layer 16 is provided on the surface of the vapor deposition film 15, and the barrier film is laminated with another film to form a laminate. Although not shown, the barrier coat layer 16 is provided on the surface of the vapor deposition film 15 of the barrier film in which the vapor deposition film 15 is provided on the first resin layer 11 side of the polymer film 10 having the first resin layer 11, the second resin layer 12, the third resin layer 13, and the fourth resin layer 14. The surface of the vapor deposition film 15 may be laminated with another film without being provided with the barrier coat layer 16.

As shown in Fig. 6, the heat sealable heat sealant film 18 containing polypropylene is laminated on the barrier coat layer 16 side of the obtained barrier film provided with the barrier coat layer 16, via an adhesive layer 17 to form a laminate. The layer structure is polymer film 10/vapor deposition film 15/barrier coat layer 16/adhesive layer 17/heat sealant film 18. A printed layer may be provided on the barrier coat layer 16 side. Further, the heat sealant film 18 may be directly laminated on the barrier coat layer 16 side. In this case, the heat sealant film 18 is laminated without the adhesive layer 17 interposed.

When the barrier coat layer 16 is not provided, the heat sealable heat sealant film 18 containing polypropylene is laminated on the vapor deposition film side of the barrier film via the adhesive layer 17 to form a laminate. The layer structure is polymer film 10/vapor deposition film 15/adhesive layer 17/heat sealant film 18. Alternatively, the heat sealant film 18 may be directly laminated on the vapor deposition film 15 side. In this case, the heat sealant film 18 is laminated without the adhesive layer 17 interposed.

A polypropylene base film 19 containing polypropylene may be laminated on the vapor deposition film 15 side of the barrier film via an adhesive layer 17, and the heat sealable heat sealant film 18 containing polypropylene may be laminated on the polypropylene base film 19 via an adhesive layer 17. The layer structure of the laminate is polymer film 10/vapor deposition film 15/adhesive layer 17/polypropylene base film 19/adhesive layer 17/heat sealant film 18. When the barrier coat layer 16 is provided on the vapor deposition film 15 side, provided is polymer film 10/vapor deposition film 15/barrier coat layer 16/adhesive layer 17/polypropylene base film 19/adhesive layer 17/heat sealant film 18. A printed layer may be provided on the surface of the barrier coat layer on the vapor deposition film 15 side. The polypropylene base film 19 may be a biaxially oriented polypropylene film. Alternatively, the heat sealant film 18 may be directly laminated on the polypropylene base film 19. In this case, the heat sealant film 18 is laminated without the adhesive layer 17 interposed.

The barrier coat layer 16 is provided on the surface of the vapor deposition film 15 of the barrier film having the fourth resin layer 14 in the polymer film 10 shown in Fig. 2, and as shown in Fig. 7, the polypropylene base film 19 containing polypropylene is laminated on the barrier coat layer 16 side via an adhesive layer 17, and the heat sealant film 18 is laminated on the fourth resin layer 14 side via an adhesive layer 17 to form a laminate. The layer structure is polypropylene base film 19/adhesive layer 17/barrier coat layer 16/vapor deposition film 15/polymer film 10 including fourth resin layer 14/adhesive layer 17/heat sealant film 18. When the barrier coat layer 16 is not provided, the polypropylene base film 19 containing polypropylene is laminated on the vapor deposition film 15 side via the adhesive layer 17. The layer structure of the laminate is polypropylene base film 19/adhesive layer 17/vapor deposition film 15/polymer film 10 including fourth resin layer 14/adhesive layer 17/heat sealant film 18. In each case, the laminate includes the polypropylene base film 19 on a side of the barrier film opposite the heat sealant film 18. The polypropylene base film 19 may be a biaxially oriented polypropylene film. A printed layer may be provided on the polypropylene base film 19. Alternatively, the heat sealant film 18 may be directly laminated on the fourth resin layer 14. In this case, the heat sealant film 18 is laminated without the adhesive layer 17 interposed.

The heat sealant film 18 contains polypropylene having a melting point of 120°C or higher as a main component. Thus, the heat resistance of the packaging material can be improved. The polypropylene is not particularly limited as long as it has a melting point of 120°C or higher. In the present specification, the "polyolefin having a melting point of 120°C or higher" means a polypropylene having a maximum peak temperature of 120°C or higher in DSC.

The heat sealant film 18 preferably includes polyethylene as the sealant material. By containing polyethylene together with polypropylene, the heat sealant film 18 can form a sea-island structure. The "sea-island structure" means a structure in which polyethylene is discontinuously dispersed in a region in which polypropylene is continuous.

When the heat sealant film 18 contains a sealant material other than polypropylene, the heat sealant film 18 is not limited to one having a sea-island structure, and may be one having a miscible blend of the two materials.

The heat sealant film 18 preferably includes a sealant material having a melting point of 150°C or higher.

A general packaging bag for heat sterilization is filled with contents and then subjected to retort treatment or boiling treatment, which may cause deterioration in gas barrier properties and heat-sealing properties. In the laminate of the present disclosure, since the heat sealant film 18 contains a polypropylene having a melting point of 150°C or higher, even when a packaging bag produced from the laminate is subjected to a heat treatment such as retort treatment or boiling treatment, a decrease in the gas barrier properties and heat sealability of the packaging bag can be effectively suppressed.

The retort treatment is a treatment in which contents are filled in a packaging bag for heat sterilization and sealed, and then the packaging bag for heat sterilization is heated in a pressurized state using steam or heated hot water. The retort treatment is classified into semi-retort treatment and high-retort treatment depending on the heating temperature. In the semi-retort treatment, for example, after the central portion of the contents reaches 121°C, the contents are held for at least 3 minutes or more. In the high-retort treatment, for example, after the central portion of the contents reaches 135°C, the contents are held for at least 3 minutes or more.

The boiling treatment is a treatment in which contents are filled in a packaging bag for heat sterilization and sealed, and then the packaging bag for heat sterilization is heated using steam or heated hot water without pressurization. In the boiling treatment, for example, after the central portion of the contents reaches 90°C, the contents are held for at least 3 minutes.

The polypropylene used in the heat sealant film 18 may be any of a homopolymer, a random copolymer and a block copolymer. Among these, a block copolymer is preferable from the viewpoint of retort treatment suitability and boiling treatment suitability. By using the block copolymer, it is possible to improve the impact resistance of the packaging bag produced using the barrier film of the present disclosure. As the block copolymer, for example, a propylene-ethylene block copolymer or the like can be used.

The adhesive used for the adhesive layer 17 may be a one-component curable adhesive, a two-component curable adhesive, or a non-curable adhesive. The adhesive may be a solvent-free adhesive or a solvent-based adhesive, but from the viewpoint of environmental load, it is preferable to use a solvent-free adhesive. Examples of the solvent-free adhesive include a polyether-based adhesive, a polyester-based adhesive, a silicone-based adhesive, an epoxy-based adhesive, and a urethane-based adhesive; among these, a two-component curable urethane-based adhesive is preferably used. The adhesive may be a combination of a modified polyolefin and a curing agent. By using an adhesive containing a modified polyolefin as a main component, it is possible to reduce hindrance to recyclability caused by the adhesive.

The thickness of the adhesive layer 17 is not particularly limited, and can be, for example, 0.1 µm or more and 10 µm or less.

### (Wet peel strength)

In the laminate of the present disclosure, when a film including a polypropylene base film and a film including a barrier film and a heat sealant film are peeled from each other in accordance with JIS K 6854-2:1999 after retort treatment at 121°C and 0.2 MPa for 30 minutes, the wet peel strength is preferably 0.3 N/15 mm or more, more preferably 0.5 N/15 mm or more, and still more preferably 1.0 N/15 mm or more. When the wet peel strength is equal to or greater than the lower limit value, in a case where the laminate of the present disclosure is used for heat sterilization, it is possible to suppress peeling between layers of the laminate and cohesive failure in a layer. A specific method for measuring the wet peel strength will be described below.

Examples of the film including a polypropylene base film include a film formed of only a polypropylene base film, and a printed film in which a printed layer is formed on one surface of a polypropylene base film.

Examples of the film including a barrier film and a heat sealant film include a film in which a barrier film and a heat sealant film are laminated via an adhesive layer.

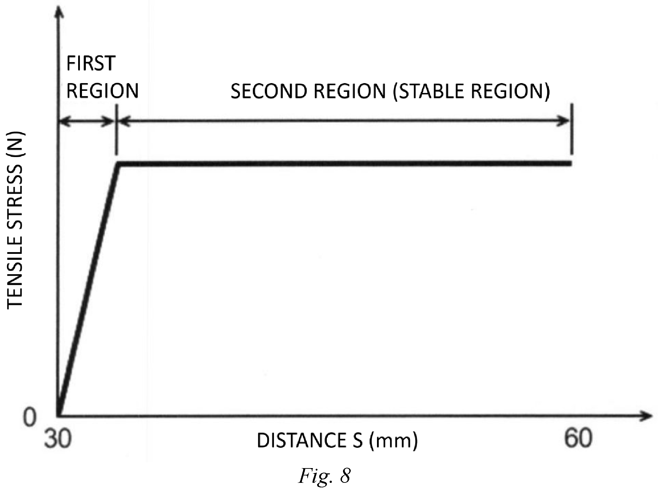

As the tensile tester, TENSILON universal material testing instrument manufactured by ORIENTEC CORPORATION is used. First, the laminate of the present disclosure is cut into an A4 size, folded to bisect the long sides so that the heat sealant film surfaces face each other, and three sides including the folded portion are heat-sealed at a width of 7 mm to produce a three-side-sealed packaging bag. This packaging bag is filled with tap water (200 mL), and sealed by heat-sealing the remaining one side to form a retort packaging bag filled with contents. Using steam, the retort packaging bag is subjected to a semi-retort treatment at 121°C and 0.2 MPa for 30 minutes. Next, the laminate is cut from the retort-treated packaging bag so that the long-side direction of a test piece coincides with the machine direction (MD direction) of the polymer film 10 to prepare the rectangular test piece having a 15 mm short side, and for the test piece, the film including the polypropylene base film and the film including the barrier film and the heat sealant film of the laminate are subjected to 15 mm peeling in the long-side direction. Thereafter, the portions where the film including the polypropylene base film and the film including the barrier film and the heat sealant film have been already peeled are gripped by a pair of grips of the measuring instrument. Water is dropped with a pipette onto a boundary portion between a portion where the film including the polypropylene base film and the film including the barrier film and the heat sealant film are maintained to be bonded to each other and a portion where the film including the polypropylene base film and the film including the barrier film and the heat sealant film have been peeled from each other when viewed along the longitudinal direction of the test piece. The pair of grips are pulled in opposite directions (180° peeling) at a rate of 50 mm/minute in a direction orthogonal to the surface direction of the portion where the film including the polypropylene base film and the film including the barrier film and the heat sealant film are still laminated, and the average value of the tensile stress in the stable region (refer to Fig. 8) is measured. The distance S between the grips at the start of pulling is 30 mm, and the distance between the grips at the end of pulling is 60 mm. Fig. 8 is a view showing a change in tensile stress with respect to the distance S between the grips. As shown in Fig. 8, the change in the tensile stress with respect to the distance S passes through a first region and enters a second region (stable region) having a smaller change rate than the first region. The average value of the tensile stress in the stable region is measured. In addition, from the packaging bag after the semi-retort treatment, the laminate is cut so that the long-side direction of a test piece coincides with the transverse direction (TD direction) of the polymer film 10 to prepare the rectangular test piece having a 15 mm short side, and for the test piece, the film including the polypropylene base film and the film including the barrier film and the heat sealant film of the laminate are subjected to 15 mm peeling in the long-side direction. Thereafter, the average value of the tensile stress in the stable region is measured in the same manner as described above. Of the smaller measured value and the larger measured value obtained as described above, the smaller measured value is defined as the wet peel strength when the film including the polypropylene base film and the film including the barrier film and the heat sealant film in the laminate are peeled from each other.

In the laminate of the present disclosure, the wet peel strength basically corresponds to the adhesion strength between the first resin layer and the vapor deposition film. However, when the adhesion strength between the first resin layer and the vapor deposition film increases, cohesive failure of the adhesive layer between the polypropylene base film and the barrier film or peeling between the polypropylene base film and the printed layer may occur; in this case, the cohesive failure strength or the peeling strength between the polypropylene base film and the printed layer corresponds to the wet peel strength. The peeled interface can be determined by evaluating the peeled portion of the test piece after measuring the wet peel strength, by FT-IR (ATR method) and XPS.

### (Packaging bag)

The heat sealant film 18 side of the laminate is used as an inner surface, and necessary portions of the heat sealant film 18 are thermally fused to each other, whereby a packaging bag can be produced. The form of the packaging bag may be any form such as a three side sealed type, a four side sealed type, a stand type, a gusset type, a pillow type, or a type with an extraction port.

Food, a seasoning, a beverage, a supplement, a pharmaceutical, an enteral formula, pet food, or the like is filled as contents in the produced packaging bag, and the packaging bag is sealed. The sealed packaging bag is subjected to boiling treatment or retort treatment. There are also packaging bags in which the contents are heated, filled, and sealed. For example, the inner surfaces of the packaging bags are sterilized by filling the contents heated to 80°C or higher.

One embodiment of the packaging bag is a heat-sterilized food pouch. As described above, the heat-sterilized food pouch is a packaging bag which contains food as contents and has been subjected to a heat sterilization treatment.

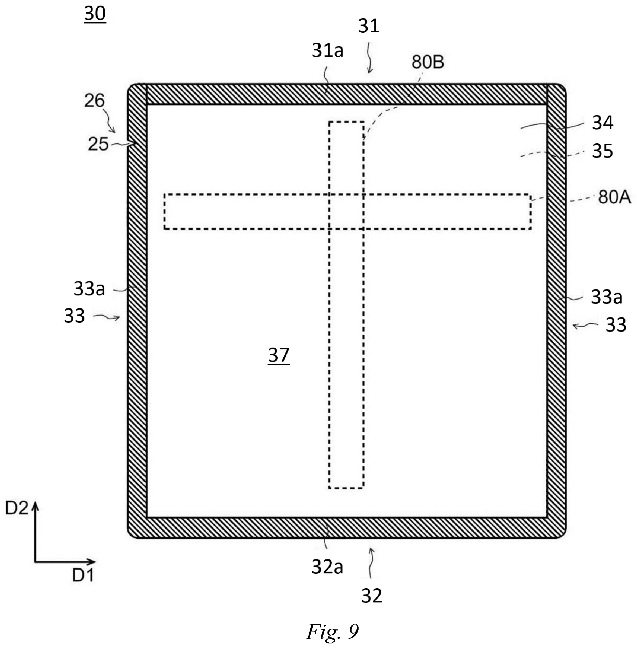

A front view of one embodiment of the packaging bag is shown in Fig. 9. A packaging bag 30 includes a storage part 37 for storing contents. Hereinafter, the configuration of the packaging bag 30 will be described.

The packaging bag 30 is a so-called flat pouch produced by joining a front side film and a back side film. The packaging bag 30 includes an upper portion 31, a lower portion 32, and a pair of side portions 33, and has a substantially rectangular outline in the front view. It should be noted that names such as "upper portion", "lower portion", and "side portion" and terms such as "upward" and "downward" merely represent relative positions and directions of the packaging bag 30 and components thereof with reference to a state in which the opening for filling contents is located at the upper portion. The orientation and the like of the packaging bag 30 during transportation and use are not limited by the names and terms in the present specification.

The width direction of the packaging bag 30 is also referred to as a first direction D1. The pair of side portions 33 described above faces each other in the first direction D1. A direction orthogonal to the first direction D1 is also referred to as a second direction D2. The packaging bag 30 of the present embodiment is intended to be used in such a manner that a user tears the packaging bag 30 along the first direction D1 to open the packaging bag 30.

As shown in Fig. 9, the packaging bag 30 includes a front surface laminate 34 constituting the front surface and a back surface laminate 35 constituting the back surface.

It should be noted that the above-described terms "front surface laminate" and "back surface laminate" are merely used to define the respective laminates in accordance with the positional relationship, and the method of providing the laminates when producing the packaging bag 30 is not limited by the above-described terms. For example, the packaging bag 30 may be produced using one laminate in which the front surface laminate 34 and the back surface laminate 35 are continuously provided, or may be produced using a total of two laminates of one front surface laminate 34 and one back surface laminate 35.

The inner surfaces of the front surface laminate 34 and the back surface laminate 35 are joined to each other by a sealed portion. In the front view of the packaging bag 30 in Fig. 9, the sealed portion is hatched.

As shown in Fig. 9, the sealed portion has an outer edge sealed portion extending along the outer edge of the packaging bag 30. The outer edge sealed portion includes a lower sealed portion 32a extending along the lower portion 32 and a pair of side sealed portions 33a extending along the pair of side portions 33. After the contents are stored in the packaging bag 30, by joining the inner surface of the front surface laminate 34 and the inner surface of the back surface laminate 35 at the upper portion 31, an upper sealed portion 31a is formed and the packaging bag 30 is sealed.

The lower sealed portion 32a, the side sealed portions 33a, and the upper sealed portion 31a are sealed portions formed by joining the inner surface of the front surface laminate 34 and the inner surface of the back surface laminate 35.

The method for forming the sealed portion is not particularly limited as long as the packaging bag 30 can be sealed by joining the opposing laminates to each other. For example, the sealed portion may be formed by melting the inner surfaces of the laminates by heating or the like and fusing the inner surfaces to each other, that is, by heat-sealing. Alternatively, the sealed portion may be formed by bonding the inner surfaces of the laminates facing each other using an adhesive or the like.

The front surface laminate 34 and the back surface laminate 35 may be provided with an easy-open means 25 for opening the packaging bag 30 by tearing the front surface laminate 34 and the back surface laminate 35 along the first direction D1. For example, as shown in Fig. 9, the easy-open means 25 may include a notch 26 which is formed in the side sealed portion 33a of the packaging bag 30 and serves as a starting point of tearing. In addition, a half-cut line formed by laser processing, a cutter, or the like may be provided as the easy-open means 25 in a portion serving as a path for tearing the packaging bag 30.

Further, although not shown, the easy-open means 25 may include a cut or a group of flaws formed in a region where the sealed portion is formed in the front surface laminate 34 and the back surface laminate 35. The group of flaws may include, for example, a plurality of through holes formed so as to penetrate through the front surface laminate 34 and/or the back surface laminate 35. Alternatively, the group of flaws may include a plurality of holes formed in the outer surface of the front surface laminate 34 and/or the back surface laminate 35 so as not to penetrate the front surface laminate 34 and/or the back surface laminate 35.

In a laminate constituting a heat-sterilized food pouch which is an embodiment of a packaging bag of the present disclosure, when the film including the polypropylene base film and the film including the barrier film and the heat sealant film are peeled from each other in accordance with JIS K 6854-2:1999, the wet peel strength is preferably 0.3 N/15 mm or more, more preferably 0.5 N/15 mm or more, still more preferably 1.0 N/15 mm or more, and further still more preferably 2.0 N/15 mm or more. In the laminate constituting the heat-sterilized food pouch, when the wet peel strength is equal to or greater than the lower limit value, it is possible to suppress peeling between layers or cohesive failure in a layer in the laminate constituting the heat-sterilized food pouch.

When the wet peel strength is measured, a test piece is prepared by cutting the laminate constituting the packaging bag 30 such that the long-side direction of the test piece coincides with the width direction (first direction D1) of the packaging bag 30, as indicated by reference sign 80A in Fig. 9. In addition, a test piece is also prepared by cutting the laminate constituting the packaging bag 30 such that the long-side direction of the test piece coincides with the direction (second direction D2) orthogonal to the width direction of the packaging bag 30, as indicated by reference sign 80B in Fig. 9. Then, the wet peel strength of the two test pieces is measured using a tensile tester. The smaller measured value is defined as the wet peel strength when the film including the polypropylene base film and the film including the barrier film and the heat sealant film are peeled from each other in the laminate constituting the heat-sterilized food pouch.

The specific method for measuring the wet peel strength of the test pieces is the same as described above.

### EXAMPLES

Hereinafter, the present disclosure will be described more specifically by way of Examples, but the present disclosure is not limited to the following Examples.

The polyamide resins used in the following Experimental Examples are as follows.

### ·Polyamide A

Amorphous aromatic polyamide
Copolymer of 1,6-hexanediamine and dicarboxylic acids having molar ratio of isophthalic acid/terephthalic acid of 7/3

### ·Polyamide B

Crystalline aromatic polyamide
Copolymer of metaxylenediamine and dicarboxylic acids having molar ratio of adipic acid/isophthalic acid of 93/7

### ·Polyamide C

Crystalline aromatic polyamide
Copolymer of metaxylenediamine and adipic acid

### ·Polyamide D

Aliphatic polyamide
Homopolymer of 6-aminohexanoic acid unit
Synthesized by ring-opening polymerization of ε-caprolactam

### [Experimental Example 1-1]

As the resin (first resin) constituting the first resin layer, a mixture of 75 mass% of polyamide A and 25 mass% of polyamide B was used.

The acid-modified product of a polypropylene random copolymer (ethylene-1-butene-propylene random copolymer graft-polymerized with 1.2 mol% of maleic anhydride, MFR: 5.0) was used as the resin (second resin) constituting the second resin layer.

Homopolypropylene (MFR: 3.0) was used as the resin (third resin) constituting the third resin layer.

As the resin (fourth resin) constituting the fourth resin layer, an ethylene-1-butene-propylene random copolymer (MFR: 5.3) was used.

The first resin, the second resin, the third resin, and the fourth resin were coextruded and then stretched 5.0 times in the machine direction (MD direction) and 10.0 times in the transverse direction (TD direction) by a sequential biaxial stretching apparatus to produce a polymer film of Experimental Example 1-1 including the first resin layer (0.7 µm), the second resin layer (1.0 µm), the third resin layer (17.0 µm), and the fourth resin layer (1.3 µm).

The thickness of the polymer film of Experimental Example 1-1 was 20 µm.

The content of polypropylene in the entire polymer film of Experimental Example 1-1 was 95 mass%.

### [Experimental Example 1-2]

A polymer film of Experimental Example 1-2 was produced in the same manner as in the polymer film of Experimental Example 1-1, except that a mixture of 70 mass% of polyamide A and 30 mass% of polyamide B was used as the first resin.

### [Experimental Example 1-3]

A polymer film of Experimental Example 1-3 was produced in the same manner as in the polymer film of Experimental Example 1-2, except that the thickness of the first resin layer was changed to 0.1 µm.

The polymer film of Experimental Example 1-3 had a thickness of 19.4 µm.

The content of polypropylene in the entire polymer film of Experimental Example 1-3 was 99 mass%.

### [Experimental Example 1-4]

A polymer film of Experimental Example 1-4 was produced in the same manner as in the polymer film of Experimental Example 1-2, except that the thickness of the first resin layer was changed to 5.0 µm.

The polymer film of Experimental Example 1-4 had a thickness of 24.3 µm.

The content of polypropylene in the entire polymer film of Experimental Example 1-4 was 74 mass%.

### [Experimental Example 1-5]

A polymer film of Experimental Example 1-5 was produced in the same manner as in the polymer film of Experimental Example 1-2, except that the thickness of the first resin layer was changed to 0.4 µm.

The polymer film of Experimental Example 1-5 had a thickness of 19.7 µm.

The content of polypropylene in the entire polymer film of Experimental Example 1-5 was 97 mass%.

### [Experimental Example 1-6]

A polymer film of Experimental Example 1-6 was produced in the same manner as in the polymer film of Experimental Example 1-2, except that the thickness of the first resin layer was changed to 1.5 µm.

The polymer film of Experimental Example 1-6 had a thickness of 20.8 µm.

The content of polypropylene in the entire polymer film of Experimental Example 1-6 was 91 mass%.

### [Experimental Example 1-7]

As the resin (first resin) constituting the first resin layer, a mixture of 70 mass% of polyamide A and 30 mass% of polyamide B was used.

The acid-modified product of a polypropylene random copolymer (ethylene-1-butene-propylene random copolymer graft-polymerized with 1.2 mol% of maleic anhydride, MFR: 5.0) was used as the resin (second resin) constituting the second resin layer.

Homopolypropylene (MFR: 3.0) was used as the resin (third resin) constituting the third resin layer.

The acid-modified product of a polypropylene random copolymer (ethylene-1-butene-propylene random copolymer graft-polymerized with 1.2 mol% of maleic anhydride, MFR: 5.0) was used as the resin (fourth resin) constituting the fourth resin layer.

As the resin (fifth resin) constituting the fifth resin layer, a mixture of 70 mass% of polyamide A and 30 mass% of polyamide B was used.

The first resin, the second resin, the third resin, the fourth resin, and the fifth resin were coextruded and then stretched 5.0 times in the machine direction (MD direction) and 10.0 times in the transverse direction (TD direction) by a sequential biaxial stretching apparatus to produce a polymer film of Experimental Example 1-7 including the first resin layer (0.7 µm), the second resin layer (1.0 µm), the third resin layer (17.0 µm), the fourth resin layer (1.0 µm), and the fifth resin layer (0.7 µm) in this order.

The polymer film of Experimental Example 1-7 had a thickness of 20.4 µm.

The content of polypropylene in the entire polymer film of Experimental Example 1-7 was 91 mass%.

### [Experimental Example 1-8]

A polymer film of Experimental Example 1-8 was produced in the same manner as in the polymer film of Experimental Example 1-1 except that a mixture of 70 mass% of polyamide A and 30 mass% of polyamide C was used as the first resin.

### [Experimental Example 1-9]

A polymer film of Experimental Example 1-9 was produced in the same manner as in the polymer film of Experimental Example 1-1 except that a mixture of 70 mass% of polyamide A, 25 mass% of polyamide C, and 5 mass% of polyamide D was used as the first resin.

### [Experimental Example 1-10]

A polymer film of Experimental Example 1-10 was produced in the same manner as in the polymer film of Experimental Example 1-1, except that a mixture of 60 mass% of polyamide A and 40 mass% of polyamide B was used as the first resin.

### [Experimental Example 1-11]

A polymer film of Experimental Example 1-11 was produced in the same manner as in the polymer film of Experimental Example 1-1, except that a mixture of 50 mass% of polyamide A and 50 mass% of polyamide B was used as the first resin.

### [Experimental Example 1-12]

A polymer film of Experimental Example 1-12 was produced in the same manner as in the polymer film of Experimental Example 1-1 except that a mixture of 35 mass% of polyamide A and 65 mass% of polyamide B was used as the first resin.

### [Experimental Example 1-13]

A polymer film of Experimental Example 1-13 was produced in the same manner as in the polymer film of Experimental Example 1-1, except that a mixture of 35 mass% of polyamide A and 65 mass% of polyamide C was used as the first resin.

### [Experimental Example 1-14]

A polymer film of Experimental Example 1-14 was produced in the same manner as in the polymer film of Experimental Example 1-1, except that a mixture of 35 mass% of polyamide A, 59 mass% of polyamide C, and 6 mass% of polyamide D was used as the first resin.

### [Experimental Example 1-15]

A polymer film of Experimental Example 1-15 was produced in the same manner as in the polymer film of Experimental Example 1-1, except that a mixture of 80 mass% of polyamide A and 20 mass% of polyamide D was used as the first resin.

### [Experimental Example 1-16]

A polymer film of Experimental Example 1-16 was produced in the same manner as in the polymer film of Experimental Example 1-1, except that a mixture of 75 mass% of polyamide A and 25 mass% of polyamide D was used as the first resin.

### [Experimental Example 1-17]

A polymer film of Experimental Example 1-17 was produced in the same manner as in the polymer film of Experimental Example 1-1, except that a mixture of 20 mass% of polyamide A and 80 mass% of polyamide C was used as the first resin.

### [Experimental Example 1-18]

A polymer film of Experimental Example 1-18 was produced in the same manner as in the polymer film of Experimental Example 1-1 except that a mixture of 20 mass% of polyamide A and 80 mass% of polyamide B was used as the first resin.

### [Experimental Example 1-19]

A polymer film of Experimental Example 1-19 was produced in the same manner as in the polymer film of Experimental Example 1-1 except that a mixture of 30 mass% of polyamide A and 70 mass% of polyamide D was used as the first resin.

### [Experimental Example 1-20]

A polymer film of Experimental Example 1-20 was produced in the same manner as in the polymer film of Experimental Example 1-1, except that a mixture of 20 mass% of polyamide A and 80 mass% of polyamide D was used as the first resin.

### [Experimental Example 1-21]

A polymer film of Experimental Example 1-21 was produced in the same manner as in the polymer film of Experimental Example 1-2, except that a mixture of 95 mass% of an ethylene-1-butene-propylene random copolymer (MFR: 5.3) and 5 mass% of a high-density polyethylene (MFR: 1.1) was used as the fourth resin.

### [Experimental Example 1-22]

A polymer film of Experimental Example 1-22 was produced in the same manner as in Experimental Example 1-11 except that homopolypropylene (MFR: 3.0) was used as the fourth resin.

### [Experimental Example 1-23]

A polymer film of Experimental Example 1-23 was produced in the same manner as in Experimental Example 1-18 except that homopolypropylene (MFR: 3.0) was used as the fourth resin.

A polymer film of Experimental Example 1-23 was produced in the same manner as in the polymer film of Experimental Example 1-22 except that a mixture of 20 mass% of polyamide A and 80 mass% of polyamide B was used as the first resin.

### [Experimental Example 1-24]

A polymer film of Experimental Example 1-24 was produced in the same manner as in the polymer film of Experimental Example 1-2, except that instead of stretching 5.0 times in the machine direction (MD direction), stretching 4.7 times in the machine direction (MD direction) was performed, and the amounts of the resins to be extruded were adjusted so that the thicknesses of the first resin layer, the second resin layer, the third resin layer, and the fourth resin layer after stretching were 0.7 µm, 1.0 µm, 17.0 µm, and 1.3 µm, respectively.

### [Experimental Example 1-25]

A polymer film of Experimental Example 1-25 was produced in the same manner as in the polymer film of Experimental Example 1-2, except that instead of stretching 5.0 times in the machine direction (MD direction), stretching 4.5 times in the machine direction (MD direction) was performed, and the amounts of the resins to be extruded were adjusted so that the thicknesses of the first resin layer, the second resin layer, the third resin layer, and the fourth resin layer after stretching were 0.7 µm, 1.0 µm, 17.0 µm, and 1.3 µm, respectively.

### [Experimental Example 1-26]

A polymer film of Experimental Example 1-26 was produced in the same manner as in the polymer film of Experimental Example 1-2, except that instead of stretching 5.0 times in the machine direction (MD direction), stretching 4.3 times in the machine direction (MD direction) was performed, and the amounts of the resins to be extruded were adjusted so that the thicknesses of the first resin layer, the second resin layer, the third resin layer, and the fourth resin layer after stretching were 0.7 µm, 1.0 µm, 17.0 µm, and 1.3 µm, respectively.

### (¹H-NMR spectrum measurement)

Each of the polymer films of Experimental Examples 1-1 to 1-26 was cut into pieces with scissors and placed in a sample vial. Chloroform (6 mL) and formic acid (4 mL) were added to the sample vial, and the mixture was allowed to stand overnight. In this way, the first resin layer constituting the polymer film was dissolved in the mixed solvent of chloroform and formic acid.

The organic solvent phase was filtered through a Chromatodisk having a filter pore size of 0.45 µm, concentrated and dried to dryness using a nitrogen blower, and used as a measurement sample.

The measurement sample (20 to 30 mg) was dissolved in a mixed solvent of deuterated chloroform (CDCl₃, 0.5 mL) and formic acid (0.5 mL), and transferred to an NMR sample tube.

The ¹H-NMR spectrum was measured using an NMR apparatus (manufactured by Bruker Japan K.K., AVANCE III HD 400 MHz) under the following measurement conditions.

### (Measurement conditions)

·Observed nucleus: ¹H
·Measurement temperature: room temperature
·Number of scans: 32
·Relaxation delay: 5 s
·Probe: PA BBO 400S1 BBF-H-D-05 Z SP
·Deuterated solvent: CDCl₃ (internal standard: TMS) + formic acid
·Window function: exponential
·Line broadening: 0.3 Hz

The pellets (20 to 30 mg) of polyamides A to D were dissolved in mixed solvents of deuterated chloroform (CDCl₃, 0.5 mL) and formic acid (0.5 mL) to prepare standard samples, and the ¹H-NMR spectra were measured in the same manner as described above.

With reference to proton-derived peaks observed in ¹H-NMR spectrum measurement of the standard samples prepared from the pellets, proton-derived peaks observed in a ¹H-NMR spectrum measurement of a measurement sample prepared from each polymer film were assigned; the number ratio of each aminocarboxylic acid unit and the number ratio of each diamine unit were calculated from the ratios of the areas of the peaks; and the ratio of the number of diamine units to the total number of aminocarboxylic acid units and diamine units and the ratio of the number of aromatic diamine units to the total number of aminocarboxylic acid units and diamine units were calculated, respectively.

### (Measurement of surface roughness Sa)

Each of the polymer films of Experimental Examples 1-1, 1-2, and 1-5 to 1-26 was placed in a chamber of an Ion Sputter apparatus (E-1030, manufactured by Hitachi Science Systems, Ltd.) with the surface of the first resin layer facing the Pt-Pd target side. After the pressure was reduced, argon gas was introduced to adjust the pressure to 10 Pa. A Pt-Pd layer was formed on the surface of the first resin layer for 60 seconds. Such a polymer film having the formed layer was cut into a 1.5 cm square piece, and fixed to a slide glass with a tape so that the layer-formed surface was on a side opposite to the slide glass.

Next, a laser microscope (manufactured by Keyence Corporation, measurement unit model number: VK-X160, control unit model number: VK-X150) was used with a 50× objective lens, a 1× zoom, a measurement quality of ultra-high speed, a pitch of 0.13 µm, and no double scanning. The field of view at this time was 203.555 µm × 271.495 µm.

The polymer film fixed to the slide glass was placed under the objective lens so that the machine direction (MD direction) and the short-side direction of the field of view were parallel to each other. A stitching range of 1 (short-side direction) × 5 (long-side direction) was specified, the upper and lower height limits of scanning and the brightness were appropriately adjusted manually, and three stitched images, each composed of five images aligned in the transverse direction (TD direction), were obtained. The size of the stitched image was 200 ± 5 µm × 1220 ± 10 µm.

In each stitched image, 0.5 mm was numerically designated in the waviness removal of the surface shape correction, and the waviness was removed. In the surface roughness measurement, the entire region of each stitched image was specified, and the surface roughness Sa was calculated. The average of the three calculated values was defined as the surface roughness Sa of one outermost layer.

The other outermost layer (the surface of the fourth resin layer in Experimental Examples 1-1, 1-2, 1-5, 1-6, 1-8 to 1-21, and 1-24 to 1-26, and the surface of the fifth resin layer in Experimental Example 1-7) was also measured in the same manner to calculate the surface roughness Sa, and the average of the three calculated values was defined as the surface roughness Sa of the fourth resin layer.

As the surface roughness Sa of the one outermost layer is smaller, the surface of the first resin layer in the polymer film after stretching is smoother, and the resin constituting the first resin layer is more suitable for film formation.

As the surface roughness Sa of the other outermost layer is larger, the surface of the other outermost layer is rougher in the polymer film after stretching, and a blocking phenomenon in which the other outermost layer adheres to one outermost layer when the polymer film is wound into a roll can be suppressed.

### (Film-forming property evaluation)

The surface state of each of the polymer films of Experimental Examples 1-1 to 1-26 was observed. The evaluation criteria were as follows.
A: No resin breakage or hole formation occurred in the first resin layer even after stretching, and the film-forming properties were good.
B: Although resin breakage and hole formation did not occur in the first resin layer even after stretching, strong curling occurred in the polymer film due to shrinkage of the first resin layer after stretching, and the film-forming properties were somewhat poor.
C: Resin breakage or hole formation occurred in the first resin layer due to stretching, and the film-forming properties were poor.

### (Winding property evaluation)

Each of the polymer films of Experimental Examples 1-1 to 1-26 was wound after film formation, and evaluated based on the following evaluation criteria.
A: No wrinkling occurred during winding.
B: Since wrinkling occurred during winding, film formation and winding had to be stopped.

The structures, measurement results, and evaluation results of the polymer films of Experimental Examples 1-1 to 1-26 are shown in Tables 1 to 5.

**[Table 1]**

| Table 1 | | Experimental Example 1-1 | Experimental Example 1-2 | Experimental Example 1-3 | Experimental Example 1-4 | Experimental Example 1-5 |
|---|---|---|---|---|---|---|
| Composition of first resin layer | | Polyamide A 75 mass% | Polyamide A 70 mass% | Polyamide A 70 mass% | Polyamide A 70 mass% | Polyamide A 70 mass% |
| | | Polyamide B 25 mass% | Polyamide B 30 mass% | Polyamide B 30 mass% | Polyamide B 30 mass% | Polyamide B 30 mass% |
| | | - | - | - | - | - |
| Thickness of first resin layer [µm] | | 0.7 | 0.7 | 0.1 | 5.0 | 0.4 |
| Composition of second resin layer | | Acid-modified random PP | Acid-modified random PP | Acid-modified random PP | Acid-modified random PP | Acid-modified random PP |
| Composition of third resin layer | | Homo PP | Homo PP | Homo PP | Homo PP | Homo PP |
| Composition of fourth resin layer | | Ter-PP 100 mass% | Ter-PP 100 mass% | Ter-PP 100 mass% | Ter-PP 100 mass% | Ter-PP 100 mass% |
| | | - | - | - | - | - |
| Composition of fifth resin layer | | - | - | - | - | - |
| | | - | - | - | - | - |
| Stretch ratio | Machine direction (MD direction) | 5.0 | 5.0 | 5.0 | 5.0 | 5.0 |
| | Transverse direction (TD direction) | 10.0 | 10.0 | 10.0 | 10.0 | 10.0 |
| Diamine units/ (aminocarboxylic acid units + diamine units) of first resin layer [mol%] | | 100.0 | 100.0 | 100.0 | 100.0 | 100.0 |
| Aromatic diamine units/ (aminocarboxylic acid units + diamine units) of first resin layer [mol%] | | 24.9 | 29.9 | 29.9 | 29.9 | 29.9 |
| Surface roughness Sa [µm] | One outermost layer | 0.044 | 0.043 | - | - | 0.043 |
| | Other outermost layer | 0.061 | 0.061 | - | - | 0.061 |
| Film-forming properties | | A | A | C | B | A |
| Winding properties | | A | A | A | A | A |

| | | | | | | |
|---|---|---|---|---|---|---|
| Acid-modified random PP: acid-modified product of polypropylene random copolymer Homo PP: homopolypropylene Ter-PP: ethylene-1-butene-propylene random copolymer | | | | | | |

**[Table 2]**

| Table 2 | | Experimental Example 1-6 | Experimental Example 1-7 | Experimental Example 1-8 | Experimental Example 1-9 | Experimental Example 1-10 |
|---|---|---|---|---|---|---|
| Composition of first resin layer | | Polyamide A 70 mass% | Polyamide A 70 mass% | Polyamide A 70 mass% | Polyamide A 70 mass% | Polyamide A 60 mass% |
| | | Polyamide B 30 mass% | Polyamide B 30 mass% | Polyamide C 30 mass% | Polyamide C 25 mass% | Polyamide B 40 mass% |
| | | - | - | - | Polyamide D 5 mass% | - |
| Thickness of first resin layer [µm] | | 1.5 | 0.7 | 0.7 | 0.7 | 0.7 |
| Composition of second resin layer | | Acid-modified random PP | Acid-modified random PP | Acid-modified random PP | Acid-modified random PP | Acid-modified random PP |
| Composition of third resin layer | | Homo PP | Homo PP | Homo PP | Homo PP | Homo PP |
| Composition of fourth resin layer | | Ter-PP 100 mass% | Acid-modified random PP 100 mass% | Ter-PP 100 mass% | Ter-PP 100 mass% | Ter-PP 100 mass% |
| | | - | - | - | - | - |
| Composition of fifth resin layer | | - | Polyamide A 70 mass% | - | - | - |
| | | - | Polyamide B 30 mass% | - | - | - |
| Stretch ratio | Machine direction (MD direction) | 5.0 | 5.0 | 5.0 | 5.0 | 5.0 |
| | Transverse direction (TD direction) | 10.0 | 10.0 | 10.0 | 10.0 | 10.0 |
| Diamine units/ (aminocarboxylic acid units + diamine units) of first resin layer [mol%] | | 100.0 | 100.0 | 100.0 | 89.7 | 100.0 |
| Aromatic diamine units/ (aminocarboxylic acid units + diamine units) of first resin layer [mol%] | | 29.9 | 30.0 | 30.0 | 23.6 | 39.9 |
| Surface roughness Sa [µm] | One outermost layer | 0.043 | 0.043 | 0.045 | 0.045 | 0.048 |
| | Other outermost layer | 0.061 | 0.043 | 0.058 | 0.058 | 0.061 |
| Film-forming properties | | A | A | A | A | A |
| Winding properties | | A | B | A | A | A |

| | | | | | | |
|---|---|---|---|---|---|---|
| Acid-modified random PP: acid-modified product of polypropylene random copolymer Homo PP: homopolypropylene Ter-PP: ethylene-1-butene-propylene random copolymer | | | | | | |

**[Table 3]**

| Table 3 | | Experimental Example 1-11 | Experimental Example 1-12 | Experimental Example 1-13 | Experimental Example 1-14 | Experimental Example 1-15 |
|---|---|---|---|---|---|---|
| Composition of first resin layer | | Polyamide A 50 mass% | Polyamide A 35 mass% | Polyamide A 35 mass% | Polyamide A 35 mass% | Polyamide A 80 mass% |
| | | Polyamide B 50 mass% | Polyamide B 65 mass% | Polyamide C 65 mass% | Polyamide C 59 mass% | - |
| | | - | - | - | Polyamide D 6 mass% | Polyamide D 20 mass% |
| Thickness of first resin layer [µm] | | 0.7 | 0.7 | 0.7 | 0.7 | 0.7 |
| Composition of second resin layer | | Acid-modified random PP | Acid-modified random PP | Acid-modified random PP | Acid-modified random PP | Acid-modified random PP |
| Composition of third resin layer | | Homo PP | Homo PP | Homo PP | Homo PP | Homo PP |
| Composition of fourth resin layer | | Ter-PP 100 mass% | Ter-PP 100 mass% | Ter-PP 100 mass% | Ter-PP 100 mass% | Ter-PP 100 mass% |
| | | - | - | - | - | - |
| Composition of fifth resin layer | | - | - | - | - | - |
| | | - | - | - | - | - |
| Stretch ratio | Machine direction (MD direction) | 5.0 | 5.0 | 5.0 | 5.0 | 5.0 |
| | Transverse direction (TD direction) | 10.0 | 10.0 | 10.0 | 10.0 | 10.0 |
| Diamine units/ (aminocarboxylic acid units + diamine units) of first resin layer [mol%] | | 100.0 | 100.0 | 100.0 | 87.8 | 64.8 |
| Aromatic diamine units/ (aminocarboxylic acid units + diamine units) of first resin layer [mol%] | | 49.9 | 64.9 | 64.9 | 55.0 | 0.0 |
| Surface roughness Sa [µm] | One outermost layer | 0.047 | 0.061 | 0.063 | 0.062 | 0.066 |
| | Other outermost layer | 0.061 | 0.061 | 0.058 | 0.058 | 0.063 |
| Film-forming properties | | A | A | A | A | A |
| Winding properties | | A | A | A | A | A |

| | | | | | | |
|---|---|---|---|---|---|---|
| Acid-modified random PP: acid-modified product of polypropylene random copolymer Homo PP: homopolypropylene Ter-PP: ethylene-1-butene-propylene random copolymer | | | | | | |

**[Table 4]**

| Table 4 | | Experimental Example 1-16 | Experimental Example 1-17 | Experimental Example 1-18 | Experimental Example 1-19 | Experimental Example 1-20 |
|---|---|---|---|---|---|---|
| Composition of first resin layer | | Polyamide A 75 mass% | Polyamide A 20 mass% | Polyamide A 20 mass% | Polyamide A 30 mass% | Polyamide A 20 mass% |
| | | - | Polyamide C 80 mass% | Polyamide B 80 mass% | - | - |
| | | Polyamide D 25 mass% | - | - | Polyamide D 70 mass% | Polyamide D 80 mass% |
| Thickness of first resin layer [µm] | | 0.7 | 0.7 | 0.7 | 0.7 | 0.7 |
| Composition of second resin layer | | Acid-modified random PP | Acid-modified random PP | Acid-modified random PP | Acid-modified random PP | Acid-modified random PP |
| Composition of third resin layer | | Homo PP | Homo PP | Homo PP | Homo PP | Homo PP |
| Composition of fourth resin layer | | Ter-PP 100 mass% | Ter-PP 100 mass% | Ter-PP 100 mass% | Ter-PP 100 mass% | Ter-PP 100 mass% |
| | | - | - | - | - | - |
| Composition of fifth resin layer | | - | - | - | - | - |
| | | - | - | - | - | - |
| Stretch ratio | Machine direction (MD direction) | 5.0 | 5.0 | 5.0 | 5.0 | 5.0 |
| | Transverse direction (TD direction) | 10.0 | 10.0 | 10.0 | 10.0 | 10.0 |
| Diamine units/ (aminocarboxylic acid units + diamine units) of first resin layer [mol%] | | 58.0 | 100.0 | 100.0 | 16.5 | 10.3 |
| Aromatic diamine units/ (aminocarboxylic acid units + diamine units) of first resin layer [mol%] | | 0.0 | 80.0 | 79.9 | 0.0 | 0.0 |
| Surface roughness Sa [µm] | One outermost layer | 0.067 | 0.302 | 0.256 | 0.063 | 0.344 |
| | Other outermost layer | 0.063 | 0.058 | 0.061 | 0.063 | 0.063 |
| Film-forming properties | | A | C | C | A | C |
| Winding properties | | A | A | A | A | A |

| | | | | | | |
|---|---|---|---|---|---|---|
| Acid-modified random PP: acid-modified product of polypropylene random copolymer Homo PP: homopolypropylene Ter-PP: ethylene-1-butene-propylene random copolymer | | | | | | |

**[Table 5]**

| Table 5 | | Experimental Example 1-21 | Experimental Example 1-22 | Experimental Example 1-23 | Experimental Example 1-24 | Experimental Example 1-25 | Experimental Example 1-26 |
|---|---|---|---|---|---|---|---|
| Composition of first resin layer | | Polyamide A 70 mass% | Polyamide A 50 mass% | Polyamide A 20 mass% | Polyamide A 70 mass% | Polyamide A 70 mass% | Polyamide A 70 mass% |
| | | Polyamide B 30 mass% | Polyamide B 50 mass% | Polyamide B 80 mass% | Polyamide B 30 mass% | Polyamide B 30 mass% | Polyamide B 30 mass% |
| | | | | | | | |
| Thickness of first resin layer [µm] | | 0.7 | 0.7 | 0.7 | 0.7 | 0.7 | 0.7 |
| Composition of second resin layer | | Acid-modified random PP | Acid-modified random PP | Acid-modified random PP | Acid-modified random PP | Acid-modified random PP | Acid-modified random PP |
| Composition of third resin layer | | Homo PP | Homo PP | Homo PP | Homo PP | Homo PP | Homo PP |
| Composition of fourth resin layer | | Ter-PP 95 mass% | Homo PP 100 mass% | Homo PP 100 mass% | Ter-PP 100 mass% | Ter-PP 100 mass% | Ter-PP 100 mass% |
| | | HDPE 5 mass% | - | - | - | - | - |
| Composition of fifth resin layer | | - | - | - | - | - | - |
| | | - | - | - | - | - | - |
| Stretch ratio | Machine direction (MD direction) | 5.0 | 5.0 | 5.0 | 4.7 | 4.5 | 4.3 |
| | Transverse direction (TD direction) | 10.0 | 10.0 | 10.0 | 10.0 | 10.0 | 10.0 |
| Diamine units/ (aminocarboxylic acid units + diamine units) of first resin layer [mol%] | | 100.0 | 100.0 | 100.0 | 100.0 | 100.0 | 100.0 |
| Aromatic diamine units/ (aminocarboxylic acid units + diamine units) of first resin layer [mol%] | | 29.9 | 49.9 | 79.9 | 29.9 | 29.9 | 29.9 |
| Surface roughness Sa [µm] | One outermost layer | 0.043 | 0.047 | 0.256 | 0.043 | 0.043 | 0.043 |
| | Other outermost layer | 0.101 | - | - | 0.061 | 0.061 | 0.061 |
| Film-forming properties | | A | A | C | A | A | A |
| Winding properties | | A | A | A | A | A | A |

| | | | | | | | |
|---|---|---|---|---|---|---|---|
| Acid-modified random PP: acid-modified product of polypropylene random copolymer Homo PP: homopolypropylene Ter-PP: ethylene-1-butene-propylene random copolymer HDPE: high-density polyethylene | | | | | | | |

As is clear from the above Tables 1 to 5, the polymer films of Experimental Examples 1-1, 1-2, 1-5, 1-6, 1-8 to 1-16, 1-19, 1-21, 1-22, and 1-24 to 1-26 were excellent in film-forming properties.

### [Experimental Example 2-1]

The polymer film of Experimental Example 1-1 was introduced into an unwinding section in a depressurizable chamber having the unwinding section, a plasma treatment section, a film forming section, a winding section, and the like, and the pressure in the chamber was reduced. The surface of the first resin layer of the polymer film of Experimental Example 1-1 was subjected to a plasma pretreatment using a mixed gas of argon and oxygen at a volume ratio of 1:1 while applying tension to the polymer film of Experimental Example 1-1 in a Roll-to-Roll manner using a plasma treatment apparatus; in the film forming section to which the polymer film was continuously transported, an aluminum oxide (alumina) vapor deposition film having a thickness of 10 nm was formed by vapor-depositing aluminum on the plasma-treated surface using a resistance-heating method as a means for heating aluminum while introducing oxygen (PVD method).

Next, a barrier coating agent was prepared by the following procedure, and a barrier coat layer was formed on the surface of the vapor deposition film.

A solution having a pH of 2.2 was prepared by mixing 385 g of water, 67 g of isopropyl alcohol, and 9.1 g of 0.5 N hydrochloric acid. Tetraethoxysilane (175 g) as a metal alkoxide was mixed to this solution while cooling to 10°C to obtain a solution A.

Polyvinyl alcohol (14.7 g) having a saponification degree of 99% or more and a polymerization degree of 2400 as a water-soluble polymer, 324 g of water and 17 g of isopropyl alcohol were mixed to obtain a solution B.

The solution A and the solution B were mixed at a mass ratio of 5.5:4.5 to obtain a barrier coating agent. The surface of the vapor deposition film was coated with the barrier coating agent and dried at 100°C for 10 seconds. The thickness of the barrier coat layer formed by drying the barrier coating agent was 300 nm.

In this manner, a barrier film of Experimental Example 2-1 was produced.

### [Experimental Example 2-2]

A barrier film of Experimental Example 2-2 was produced in the same manner as in Experimental Example 2-1 except that the polymer film of Experimental Example 1-2 was used instead of the polymer film of Experimental Example 1-1.

### [Experimental Example 2-3]

A barrier film of Experimental Example 2-3 was produced in the same manner as in Experimental Example 2-1, except that the polymer film of Experimental Example 1-8 was used instead of the polymer film of Experimental Example 1-1.

### [Experimental Example 2-4]

A barrier film of Experimental Example 2-4 was produced in the same manner as in Experimental Example 2-1, except that the polymer film of Experimental Example 1-9 was used instead of the polymer film of Experimental Example 1-1.

### [Experimental Example 2-5]

A barrier film of Experimental Example 2-5 was produced in the same manner as in Experimental Example 2-1, except that the polymer film of Experimental Example 1-10 was used instead of the polymer film of Experimental Example 1-1.

### [Experimental Example 2-6]

A barrier film of Experimental Example 2-6 was produced in the same manner as in Experimental Example 2-1, except that the polymer film of Experimental Example 1-11 was used instead of the polymer film of Experimental Example 1-1.

### [Experimental Example 2-7]

A barrier film of Experimental Example 2-7 was produced in the same manner as in Experimental Example 2-1 except that the polymer film of Experimental Example 1-12 was used instead of the polymer film of Experimental Example 1-1.

### [Experimental Example 2-8]

A barrier film of Experimental Example 2-8 was produced in the same manner as in Experimental Example 2-1 except that the polymer film of Experimental Example 1-13 was used instead of the polymer film of Experimental Example 1-1.

### [Experimental Example 2-9]

A barrier film of Experimental Example 2-9 was produced in the same manner as in Experimental Example 2-1 except that the polymer film of Experimental Example 1-14 was used instead of the polymer film of Experimental Example 1-1.

### [Experimental Example 2-10]

A barrier film of Experimental Example 2-10 was produced in the same manner as in Experimental Example 2-2, except that the formation of the vapor deposition film was changed as follows.

The surface of the first resin layer of the polymer film of Experimental Example 1-2 was subjected to a plasma pretreatment using a mixed gas of argon and oxygen at a volume ratio of 1:1. Silicon oxide was vapor-deposited on the plasma-treated surface using an electron beam heating system as a heating means and silicon monoxide as a vapor deposition source to form a silicon oxide vapor deposition film having a thickness of 30 nm (PVD method).

### [Experimental Example 2-11]

A barrier film of Experimental Example 2-11 was produced in the same manner as in Experimental Example 2-10 except that the barrier coat layer was not formed.

### [Experimental Example 2-12]

A barrier film of Experimental Example 2-12 was produced in the same manner as in Experimental Example 2-11, except that a silicon oxide vapor deposition film having a thickness of 30 nm was formed on the surface of the first resin layer of the polymer film of Experimental Example 1-2 without performing the plasma pretreatment.

### [Experimental Example 2-13]

A barrier film of Experimental Example 2-13 was produced in the same manner as in Experimental Example 2-10, except that the polymer film of Experimental Example 1-21 was used instead of the polymer film of Experimental Example 1-2.

### [Experimental Example 2-14]

A barrier film of Experimental Example 2-14 was produced in the same manner as in Experimental Example 2-10 except that the polymer film of Experimental Example 1-5 was used instead of the polymer film of Experimental Example 1-2.

### [Experimental Example 2-15]

A barrier film of Experimental Example 2-15 was produced in the same manner as in Experimental Example 2-10, except that the polymer film of Experimental Example 1-6 was used instead of the polymer film of Experimental Example 1-2.

### [Experimental Example 2-16]

A barrier film of Experimental Example 2-16 was produced in the same manner as in Experimental Example 2-10, except that the polymer film of Experimental Example 1-24 was used instead of the polymer film of Experimental Example 1-2.

### [Experimental Example 2-17]

A barrier film of Experimental Example 2-17 was produced in the same manner as in Experimental Example 2-10, except that the polymer film of Experimental Example 1-25 was used instead of the polymer film of Experimental Example 1-2.

### [Experimental Example 2-18]

A barrier film of Experimental Example 2-18 was produced in the same manner as in Experimental Example 2-10, except that the polymer film of Experimental Example 1-26 was used instead of the polymer film of Experimental Example 1-2.

### [Experimental Example 2-19]

A barrier film of Experimental Example 2-19 was produced in the same manner as in Experimental Example 2-10, except that the polymer film of Experimental Example 1-12 was used instead of the polymer film of Experimental Example 1-2.

### [Experimental Example 2-20]

A barrier film of Experimental Example 2-20 was produced in the same manner as in Experimental Example 2-19 except that the barrier coat layer was not formed.

### [Experimental Example 2-21]

A barrier film of Experimental Example 2-21 was produced in the same manner as in Experimental Example 2-2, except that the formation of the vapor deposition film was changed as follows.

Using a plasma chemical vapor deposition apparatus (plasma CVD apparatus), a carbon-containing silicon oxide vapor deposition film having a thickness of 30 nm was formed on the surface of the first resin layer of the polymer film of Experimental Example 1-2 in a Roll-to-Roll manner while applying tension to the polymer film of Experimental Example 1-2. The conditions for forming the vapor deposition film were as follows.

### (Forming conditions)

·Hexamethyldisiloxane:oxygen gas:helium = 1:10:10 (unit: slm)
·Cooling-electrode drum supply power: 22 kW
·Line speed: 40 m/min

### [Experimental Example 2-22]

A barrier film of Experimental Example 2-22 was produced in the same manner as in Experimental Example 2-21 except that the barrier coat layer was not formed.

### [Experimental Example 2-23]

A barrier film of Experimental Example 2-23 was produced in the same manner as in Experimental Example 2-21, except that the polymer film of Experimental Example 1-12 was used instead of the polymer film of Experimental Example 1-2.

### [Experimental Example 2-24]

A barrier film of Experimental Example 2-24 was produced in the same manner as in Experimental Example 2-23 except that the barrier coat layer was not formed.

### [Experimental Example 2-25]

A barrier film of Experimental Example 2-25 was produced in the same manner as in Experimental Example 2-1, except that the polymer film of Experimental Example 1-15 was used instead of the polymer film of Experimental Example 1-1.

### [Experimental Example 2-26]

A barrier film of Experimental Example 2-26 was produced in the same manner as in Experimental Example 2-1, except that the polymer film of Experimental Example 1-16 was used instead of the polymer film of Experimental Example 1-1.

### [Experimental Example 2-27]

A barrier film of Experimental Example 2-27 was produced in the same manner as in Experimental Example 2-1, except that the polymer film of Experimental Example 1-17 was used instead of the polymer film of Experimental Example 1-1.

### [Experimental Example 2-28]

A barrier film of Experimental Example 2-28 was produced in the same manner as in Experimental Example 2-1, except that the polymer film of Experimental Example 1-18 was used instead of the polymer film of Experimental Example 1-1.

### [Experimental Example 2-29]

A barrier film of Experimental Example 2-29 was produced in the same manner as in Experimental Example 2-1, except that the polymer film of Experimental Example 1-19 was used instead of the polymer film of Experimental Example 1-1.

### [Experimental Example 2-30]

A barrier film of Experimental Example 2-30 was produced in the same manner as in Experimental Example 2-1, except that the polymer film of Experimental Example 1-20 was used instead of the polymer film of Experimental Example 1-1.

### [Experimental Example 2-31]

A barrier film of Experimental Example 2-31 was produced in the same manner as in Experimental Example 2-2, except that the formation of the vapor deposition film was changed as follows.

The surface of the first resin layer of the polymer film of Experimental Example 1-2 was subjected to a plasma pretreatment using a mixed gas of argon and oxygen at a volume ratio of 1:1. On the plasma-treated surface, an aluminum vapor deposition film having a thickness of 30 nm was formed using a conventional vacuum metallization technique.

### [Experimental Example 2-32]

A barrier film of Experimental Example 2-32 was produced in the same manner as in Experimental Example 2-1, except that the polymer film of Experimental Example 1-22 was used instead of the polymer film of Experimental Example 1-1.

### [Experimental Example 2-33]

A barrier film of Experimental Example 2-33 was produced in the same manner as in Experimental Example 2-1, except that the polymer film of Experimental Example 1-23 was used instead of the polymer film of Experimental Example 1-1.

### (Evaluation of gas barrier properties of barrier film)

The barrier films of Experimental Examples 2-1 to 2-33 were cut to obtain test pieces. Using these test pieces, the oxygen transmission rate (unit: cc/(m²·day·atm)) and the water vapor transmission rate (unit: g/ (m²·day)) were measured by the following methods.

### [Oxygen transmission rate]

Using an oxygen transmission rate measuring apparatus (manufactured by MOCON, Inc., OX-TRAN2/20), the test piece was set so that the polymer film side of the test piece was the oxygen-supplying side, and the oxygen transmission rate was measured in an environment at a temperature of 23°C and a relative humidity of 90% RH in accordance with JIS K 7126-2:2006.

### [Water vapor transmission rate]

Using a water vapor transmission rate measuring apparatus (manufactured by MOCON, Inc., PERMATRAN-W 3/33), the test piece was set so that the polymer film side of the test piece was the water vapor supplying side, and the water vapor transmission rate was measured in an environment at a temperature of 40°C and a relative humidity of 90% RH in accordance with JIS K 7129-2:2019.

### (Production of laminate)

A biaxially oriented polypropylene film having a thickness of 20 µm was prepared as a polypropylene base film. A urethane-based printing ink was applied to one surface of the polypropylene base film by a gravure roll coating method to form a printed layer. The dry thickness of the printed layer was 1 µm. Hereinafter, the polypropylene base film on which the printed layer is formed is referred to as a printed film.

The printed layer of the printed film and the surface of the barrier coat layer of the barrier film of Experimental Example 2-1 were bonded to each other with a two-component curable polyurethane adhesive. The thickness of the adhesive layer formed by the two-component curable polyurethane adhesive was 2 µm.

Next, an unstretched polypropylene film having a thickness of 60 µm was prepared as a heat sealant film. The surface of the fourth resin layer of the barrier film of Experimental Example 2-1 and the heat sealant film were bonded to each other with a two-component curable polyurethane adhesive. The thickness of the adhesive layer formed by the two-component curable polyurethane adhesive was 2 µm.

In this way, a laminate was produced.

Laminates were produced in the same manner by using each of the barrier films of Experimental Examples 2-2 to 2-33 instead of the barrier film of Experimental Example 2-1. In the barrier films of Experimental Examples 2-11, 2-12, 2-20, 2-22, and 2-24 in which the barrier coat layer was not formed, the printed layer was bonded to the surface of the vapor deposition film of the barrier film instead of bonding the printed layer to the surface of the barrier coat layer of the barrier film.

### (Evaluation of gas barrier properties of laminates)

The laminates produced from the barrier films of Experimental Examples 2-1 to 2-33 were cut to obtain test pieces. Using these test pieces, the oxygen transmission rate and the water vapor transmission rate were measured in the same manner as described above.

### (Evaluation of gas barrier properties after semi-retort treatment)

Each of the laminates produced from the barrier films of Experimental Examples 2-1 to 2-33 was cut into an A4 size, folded to bisect the long sides so that the heat sealant film surfaces faced each other, and three sides including the folded portion were heat-sealed at a width of 7 mm to produce a three-side-sealed packaging bag. The packaging bag was filled with tap water (200 mL), and sealed by heat-sealing the remaining one side to form a retort packaging bag filled with contents. Using steam, the retort packaging bag was subjected to a semi-retort treatment at 121°C and 0.2 MPa for 30 minutes. The laminate was cut out from the retort packaging bag after the semi-retort treatment, and the oxygen transmission rate and the water vapor transmission rate were measured in the same manner as described above.

### (Evaluation of gas barrier properties after high-retort treatment)

Each of the laminates produced from the barrier films of Experimental Examples 2-1 to 2-33 was cut into an A4 size, folded to bisect the long sides so that the heat sealant film surfaces faced each other, and three sides including the folded portion were heat-sealed at a width of 7 mm to produce a three-side-sealed packaging bag. The packaging bag was filled with tap water (200 mL), and sealed by heat-sealing the remaining one side to form a retort packaging bag filled with contents. Using steam, the retort packaging bag was subjected to a high-retort treatment at 135°C and 0.3 MPa for 30 minutes. The laminate was cut out from the retort packaging bag after the high-retort treatment, and the oxygen transmission rate and the water vapor transmission rate were measured in the same manner as described above.

### (Evaluation of gas barrier properties after bending of laminates after high-retort treatment)

The laminates produced from the barrier films of Experimental Examples 2-1 to 2-33 were cut into 320 mm × 440 mm, folded to bisect the long sides so that the heat sealant film surfaces faced each other, and three sides including the folded portion were heat-sealed at a width of 7 mm to produce a three-side-sealed packaging bag. The packaging bag was filled with tap water (400 mL), and sealed by heat-sealing the remaining one side to obtain a retort packaging bag filled with contents. Using steam, the retort packaging bag was subjected to a high-retort treatment at 135°C and 0.3 MPa for 30 minutes. A laminate of 297 mm × 210 mm was cut out from the retort packaging bag after the high-retort treatment, and a bending load (stroke: 155 mm, bending motion: 440°) was applied 10 times in accordance with ASTM F 392 using a Gelbo flex tester (manufactured by TESTER SANGYO CO., LTD.). After the bending load, the oxygen transmission rate and the water vapor transmission rate of the laminate were measured in the same manner as above.

### (Measurement of wet peel strength after semi-retort treatment)

For the laminates produced from the barrier films of Experimental Examples 2-1 to 2-33, the wet peel strength was measured according to the above-described measurement method for the wet peel strength of the laminate of the present disclosure. As a measuring instrument, a TENSILON universal material testing instrument, trade name: STA-1150, manufactured by ORIENTEC CORPORATION was used.

### (Bag breakage test)

The laminates produced from the barrier films of Experimental Examples 2-1 to 2-33 were cut into an A4 size, folded to bisect the long sides so that the heat sealant film surfaces faced each other, and three sides including the folded portion were heat-sealed at a width of 7 mm to produce a three-side-sealed packaging bag. The packaging bag was filled with tap water (200 mL), and sealed by heat-sealing the remaining one side to form a retort packaging bag filled with contents. The retort packaging bag was subjected to a semi-retort treatment at 121°C for 30 minutes. The retort packaging bag after retort treatment was dropped 5 times horizontally and 5 times vertically with respect to the long-side direction of the packaging bag from the height of 150 cm, and the presence or absence of breakage of the bag was determined.

Tables 6 to 11 show the configurations and measurement results of Experimental Examples 2-1 to 2-33.

Experimental Examples 2-25 to 2-30 and 2-33 are comparative examples.

**[Table 6]**

| Table 6 | | Experimental Example 2-1 | Experimental Example 2-2 | Experimental Example 2-3 | Experimental Example 2-4 | Experimental Example 2-5 | Experimental Example 2-6 |
|---|---|---|---|---|---|---|---|
| Barrier coat layer | | TEOS and PVA | TEOS and PVA | TEOS and PVA | TEOS and PVA | TEOS and PVA | TEOS and PVA |
| Vapor deposition film | Type | Aluminum oxide | Aluminum oxide | Aluminum oxide | Aluminum oxide | Aluminum oxide | Aluminum oxide |
| | Plasma pretreatment | Performed | Performed | Performed | Performed | Performed | Performed |
| Polymer film | | Experimental Example 1-1 | Experimental Example 1-2 | Experimental Example 1-8 | Experimental Example 1-9 | Experimental Example 1-10 | Experimental Example 1-11 |
| Oxygen transmission rate [cc/(m²·day·atm)] | Barrier film | 0.3 | 0.3 | 0.5 | 0.6 | 0.5 | 0.5 |
| | Laminate | 0.2 | 0.3 | 0.4 | 0.5 | 0.5 | 0.4 |
| | After semi-retort treatment | 0.4 | 0.4 | 0.4 | 0.8 | 0.6 | 0.6 |
| | After high-retort treatment | 0.6 | 0.6 | 0.7 | 1.1 | 0.9 | 0.9 |
| | After high-retort treatment and after bending treatment | 0.7 | 0.8 | 1.0 | 1.6 | 1.2 | 1.1 |
| Water vapor transmission rate [g/(m²·day)] | Barrier film | 0.5 | 0.6 | 0.6 | 0.6 | 0.7 | 0.6 |
| | Laminate | 0.4 | 0.4 | 0.5 | 0.4 | 0.4 | 0.5 |
| | After semi-retort treatment | 0.5 | 0.5 | 0.6 | 0.5 | 0.5 | 0.6 |
| | After high-retort treatment | 0.6 | 0.5 | 0.6 | 0.6 | 0.6 | 0.7 |
| | After high-retort treatment and after bending treatment | 0.6 | 0.6 | 0.7 | 0.9 | 0.7 | 0.9 |
| Wet peel strength after semi-retort treatment [N/15mm] | | 0.8 | 0.9 | 0.8 | 0.5 | 0.8 | 0.7 |
| Bag breakage test | | No bag breakage | No bag breakage | No bag breakage | No bag breakage | No bag breakage | No bag breakage |

| | | | | | | | |
|---|---|---|---|---|---|---|---|
| TEOS: tetraethoxysilane PVA: polyvinyl alcohol | | | | | | | |

**[Table 7]**

| Table 7 | | Experimental Example 2-7 | Experimental Example 2-8 | Experimental Example 2-9 | Experimental Example 2-10 | Experimental Example 2-11 | Experimental Example 2-12 |
|---|---|---|---|---|---|---|---|
| Barrier coat layer | | TEOS and PVA | TEOS and PVA | TEOS and PVA | TEOS and PVA | - | - |
| Vapor deposition film | Type | Aluminum oxide | Aluminum oxide | Aluminum oxide | Silicon oxide | Silicon oxide | Silicon oxide |
| | Plasma pretreatment | Performed | Performed | Performed | Performed | Performed | Not performed |
| Polymer film | | Experimental Example 1-12 | Experimental Example 1-13 | Experimental Example 1-14 | Experimental Example 1-2 | Experimental Example 1-2 | Experimental Example 1-2 |
| Oxygen transmission rate [cc/(m²·day·atm)] | Barrier film | 0.6 | 0.7 | 0.8 | 0.2 | 0.4 | 0.6 |
| | Laminate | 0.4 | 0.6 | 0.6 | 0.1 | 0.2 | 0.5 |
| | After semi-retort treatment | 0.5 | 0.7 | 1.1 | 0.3 | 0.5 | 1.4 |
| | After high-retort treatment | 0.8 | 0.9 | 1.5 | 0.4 | 0.8 | 1.8 |
| | After high-retort treatment and after bending treatment | 1.0 | 1.2 | 1.8 | 0.6 | 1.1 | 2.4 |
| Water vapor transmission rate [g/(m²·day)] | Barrier film | 0.8 | 0.8 | 0.9 | 0.4 | 0.5 | 0.9 |
| | Laminate | 0.6 | 0.5 | 0.6 | 0.3 | 0.4 | 0.9 |
| | After semi-retort treatment | 0.7 | 0.7 | 0.8 | 0.4 | 0.7 | 1.4 |
| | After high-retort treatment | 0.7 | 0.8 | 0.9 | 0.5 | 0.8 | 1.7 |
| | After high-retort treatment and after bending treatment | 0.8 | 0.9 | 1.4 | 0.6 | 1.0 | 1.7 |
| Wet peel strength after semi-retort treatment [N/15mm] | | 0.7 | 0.7 | 0.5 | 0.8 | 2.4 | 0.3 |
| Bag breakage test | | No bag breakage | No bag breakage | No bag breakage | No bag breakage | No bag breakage | No bag breakage |

| | | | | | | | |
|---|---|---|---|---|---|---|---|
| TEOS: tetraethoxysilane PVA: polyvinyl alcohol | | | | | | | |

**[Table 8]**

| Table 8 | | Experimental Example 2-13 | Experimental Example 2-14 | Experimental Example 2-15 | Experimental Example 2-16 | Experimental Example 2-17 | Experimental Example 2-18 |
|---|---|---|---|---|---|---|---|
| Barrier coat layer | | TEOS and PVA | TEOS and PVA | TEOS and PVA | TEOS and PVA | TEOS and PVA | TEOS and PVA |
| Vapor deposition film | Type | Silicon oxide | Silicon oxide | Silicon oxide | Silicon oxide | Silicon oxide | Silicon oxide |
| | Plasma pretreatment | Performed | Performed | Performed | Performed | Performed | Performed |
| Polymer film | | Experimental Example 1-21 | Experimental Example 1-5 | Experimental Example 1-6 | Experimental Example 1-24 | Experimental Example 1-25 | Experimental Example 1-26 |
| Oxygen transmission rate [cc/(m²·day·atm)] | Barrier film | 0.3 | 0.3 | 0.3 | 0.2 | 0.3 | 0.4 |
| | Laminate | 0.3 | 0.3 | 0.2 | 0.1 | 0.1 | 0.2 |
| | After semi-retort treatment | 0.3 | 0.4 | 0.2 | 0.2 | 0.3 | 0.3 |
| | After high-retort treatment | 0.5 | 0.7 | 0.5 | 0.5 | 0.6 | 0.4 |
| | After high-retort treatment and after bending treatment | 1.1 | 1.2 | 0.8 | 0.6 | 0.7 | 0.6 |
| Water vapor transmission rate [g/(m²·day)] | Barrier film | 0.4 | 0.6 | 0.5 | 0.4 | 0.5 | 0.5 |
| | Laminate | 0.6 | 0.6 | 0.4 | 0.3 | 0.4 | 0.4 |
| | After semi-retort treatment | 0.6 | 0.7 | 0.5 | 0.5 | 0.5 | 0.4 |
| | After high-retort treatment | 0.7 | 0.8 | 0.6 | 0.6 | 0.5 | 0.5 |
| | After high-retort treatment and after bending treatment | 0.8 | 0.8 | 0.6 | 0.7 | 0.6 | 0.6 |
| Wet peel strength after semi-retort treatment [N/15mm] | | 0.9 | 1.1 | 1.2 | 0.8 | 0.9 | 0.8 |
| Bag breakage test | | No bag breakage | No bag breakage | No bag breakage | No bag breakage | No bag breakage | No bag breakage |

| | | | | | | | |
|---|---|---|---|---|---|---|---|
| TEOS: tetraethoxysilane PVA: polyvinyl alcohol | | | | | | | |

**[Table 9]**

| Table 9 | | Experimental Example 2-19 | Experimental Example 2-20 | Experimental Example 2-21 | Experimental Example 2-22 | Experimental Example 2-23 | Experimental Example 2-24 |
|---|---|---|---|---|---|---|---|
| Barrier coat layer | | TEOS and PVA | - | TEOS and PVA | - | TEOS and PVA | - |
| Vapor deposition film | Type | Silicon oxide | Silicon oxide | Carbon-containing silicon oxide | Carbon-containing silicon oxide | Carbon-containing silicon oxide | Carbon-containing silicon oxide |
| | Plasma pretreatment | Performed | Performed | Performed | Performed | Performed | Performed |
| Polymer film | | Experimental Example 1-12 | Experimental Example 1-12 | Experimental Example 1-2 | Experimental Example 1-2 | Experimental Example 1-12 | Experimental Example 1-12 |
| Oxygen transmission rate [cc/(m²·day·atm)] | Barrier film | 0.3 | 0.4 | 0.2 | 0.5 | 0.4 | 0.6 |
| | Laminate | 0.2 | 0.3 | 0.3 | 0.4 | 0.3 | 0.4 |
| | After semi-retort treatment | 0.4 | 0.7 | 0.5 | 0.8 | 0.6 | 1.1 |
| | After high-retort treatment | 0.6 | 0.9 | 0.7 | 1.2 | 0.9 | 1.4 |
| | After high-retort treatment and after bending treatment | 0.7 | 1.3 | 0.7 | 1.3 | 1.0 | 1.5 |
| Water vapor transmission rate [g/(m²·day)] | Barrier film | 0.5 | 0.6 | 0.4 | 0.6 | 0.4 | 0.7 |
| | Laminate | 0.4 | 0.5 | 0.4 | 0.5 | 0.3 | 0.6 |
| | After semi-retort treatment | 0.5 | 0.8 | 0.6 | 0.8 | 0.6 | 0.8 |
| | After high-retort treatment | 0.6 | 1.1 | 0.8 | 1.1 | 0.7 | 1.1 |
| | After high-retort treatment and after bending treatment | 0.6 | 1.3 | 1.0 | 1.3 | 0.9 | 1.4 |
| Wet peel strength after semi-retort treatment [N/15mm] | | 0.6 | 1.9 | 2.2 | 2.1 | 2.1 | 2.1 |
| Bag breakage test | | No bag breakage | No bag breakage | No bag breakage | No bag breakage | No bag breakage | No bag breakage |

| | | | | | | | |
|---|---|---|---|---|---|---|---|
| TEOS: tetraethoxysilane PVA: polyvinyl alcohol | | | | | | | |

**[Table 10]**

| Table 10 | | Experimental Example 2-25 | Experimental Example 2-26 | Experimental Example 2-27 | Experimental Example 2-28 | Experimental Example 2-29 | Experimental Example 2-30 |
|---|---|---|---|---|---|---|---|
| Barrier coat layer | | TEOS and PVA | TEOS and PVA | TEOS and PVA | TEOS and PVA | TEOS and PVA | TEOS and PVA |
| Vapor deposition film | Type | Aluminum oxide | Aluminum oxide | Aluminum oxide | Aluminum oxide | Aluminum oxide | Aluminum oxide |
| | Plasma pretreatment | Performed | Performed | Performed | Performed | Performed | Performed |
| Polymer film | | Experimental Example 1-15 | Experimental Example 1-16 | Experimental Example 1-17 | Experimental Example 1-18 | Experimental Example 1-19 | Experimental Example 1-20 |
| Oxygen transmission rate [cc/(m²·day·atm)] | Barrier film | 0.8 | 0.8 | 2.9 | 1.7 | 0.8 | 3.5 |
| | Laminate | 0.8 | 0.8 | 2.7 | 1.5 | 0.6 | 3.4 |
| | After semi-retort treatment | 2.3 | 2.7 | 2.8 | 2.1 | 5.9 | 8.1 |
| | After high-retort treatment | 5.1 | 6.5 | 3.9 | 3.5 | 8.6 | 12.5 |
| | After high-retort treatment and after bending treatment | 6.8 | 8.2 | 4.6 | 4.3 | 11.1 | 14.2 |
| Water vapor transmission rate [g/(m²·day)] | Barrier film | 0.8 | 0.9 | 2.8 | 2.4 | 1.3 | 3.8 |
| | Laminate | 0.6 | 0.7 | 1.9 | 1.6 | 0.8 | 2.1 |
| | After semi-retort treatment | 1.6 | 1.9 | 1.9 | 1.7 | 1.2 | 2.1 |
| | After high-retort treatment | 1.6 | 2.1 | 2.0 | 1.7 | 1.6 | 2.1 |
| | After high-retort treatment and after bending treatment | 1.8 | 2.3 | 2.1 | 1.8 | 1.9 | 2.1 |
| Wet peel strength after semi-retort treatment [N/15mm] | | 0.2 | 0.2 | 0.1 | 0.1 | 0.1 | 0.2 |
| Bag breakage test | | No bag breakage | No bag breakage | No bag breakage | No bag breakage | No bag breakage | No bag breakage |

| | | | | | | | |
|---|---|---|---|---|---|---|---|
| TEOS: tetraethoxysilane PVA: polyvinyl alcohol | | | | | | | |

**[Table 11]**

| Table 11 | | Experimental Example 2-31 | Experimental Example 2-32 | Experimental Example 2-33 |
|---|---|---|---|---|
| Barrier coat layer | | - | TEOS and PVA | TEOS and PVA |
| Vapor deposition film | Type | Aluminum | Aluminum oxide | Aluminum oxide |
| | Plasma pretreatment | Performed | Performed | Performed |
| Polymer film | | Experimental Example 1-2 | Experimental Example 1-22 | Experimental Example 1-23 |
| Oxygen transmission rate [cc/(m²·day·atm)] | Barrier film | 0.8 | 0.6 | 1.8 |
| | Laminate | 0.7 | 0.4 | 1.5 |
| | After semi-retort treatment | 1.9 | 0.6 | 2.2 |
| | After high-retort treatment | 3.5 | 1.1 | 3.5 |
| | After high-retort treatment and after bending treatment | 4.5 | 1.3 | 3.9 |
| Water vapor transmission rate [g/(m²·day)] | Barrier film | 0.8 | 0.6 | 2.4 |
| | Laminate | 0.8 | 0.5 | 1.5 |
| | After semi-retort treatment | 2.1 | 0.7 | 1.8 |
| | After high-retort treatment | 2.1 | 0.7 | 1.8 |
| | After high-retort treatment and after bending treatment | 2.1 | 0.9 | 1.8 |
| Wet peel strength after semi-retort treatment [N/15mm] | | 0.6 | 0.7 | 0.1 |
| Bag breakage test | | No bag breakage | Bag breakage occurred | Bag breakage occurred |

| | | | | |
|---|---|---|---|---|
| TEOS: tetraethoxysilane PVA: polyvinyl alcohol | | | | |

As is clear from Tables 6 to 11 above, the laminates produced from the barrier films of Experimental Examples 2-1 to 2-24 were excellent in retort resistance.

### Reference Signs List

10 polymer film
11 first resin layer
12 second resin layer
13 third resin layer
14 fourth resin layer
15 vapor deposition film
16 barrier coat layer
17 adhesive layer
18 heat sealant film
19 polypropylene base film
25 easy-open means
26 notch
30 packaging bag
31 upper portion
31a upper sealed portion
32 lower portion
32a lower sealed portion
33 side portion
33a side sealed portion
34 front surface laminate
35 back surface laminate
37 storage part
D1 first direction
D2 second direction
S distance

## Claims

1. A barrier film comprising a vapor deposition film on a side of a first resin layer of a polymer film,
wherein the polymer film includes the first resin layer, a second resin layer, and a third resin layer in this order,
the first resin layer constitutes one outermost layer of the polymer film,
the first resin layer includes a polyamide resin, the polyamide resin includes an aromatic polyamide,
a ratio of a number of diamine units contained in the aromatic polyamide to a total number of aminocarboxylic acid units and diamine units contained in the polyamide resin constituting the first resin layer is 85 mol% or more,
a ratio of a number of aromatic diamine units contained in the aromatic polyamide to the total number of aminocarboxylic acid units and diamine units contained in the polyamide resin constituting the first resin layer is 15 mol% or more and 70 mol% or less,
a content of an amorphous aromatic polyamide in the first resin layer is 25 mass% or more,
the second resin layer includes an acid-modified product of polypropylene,
the third resin layer includes homopolypropylene, and
the vapor deposition film includes an inorganic oxide.

2. The barrier film according to claim 1, wherein the polyamide resin included in the first resin layer is of two types, a first polyamide and a second polyamide,
the first polyamide is the amorphous aromatic polyamide, and
the second polyamide is a crystalline aromatic polyamide.

3. The barrier film according to claim 1, wherein the polyamide resin included in the first resin layer is of three types, a first polyamide, a second polyamide, and a third polyamide,
the first polyamide is the amorphous aromatic polyamide,
the second polyamide is a crystalline aromatic polyamide, and
the third polyamide is an aliphatic polyamide.

4. The barrier film according to claim 3, wherein a content of the third polyamide in the first resin layer is 1 mass% or more and 75 mass% or less.

5. The barrier film according to any one of claims 2 to 4, wherein a content of the first polyamide in the first resin layer is 25 mass% or more and 95 mass% or less.

6. The barrier film according to any one of claims 2 to 4, wherein a content of the second polyamide in the first resin layer is 5 mass% or more and 75 mass% or less.

7. The barrier film according to any one of claims 1 to 4, wherein a content of polypropylene in the polymer film is 70 mass% or more.

8. The barrier film according to any one of claims 1 to 4, wherein a thickness of the third resin layer is largest among thicknesses of the first resin layer, the second resin layer, and the third resin layer, and
thicknesses of layers constituting the polymer film satisfy the following formulae (1) and (2): $Thickness of first resin layer \leq \left(Thickness of polymer film\right) / 10$ (1) $Thickness of second resin layer \leq \left(Thickness of polymer film\right) / 5$ (2).

9. The barrier film according to any one of claims 1 to 4, wherein the polymer film includes a fourth resin layer on a side of the third resin layer opposite the second resin layer, and
the fourth resin layer includes a copolymer of propylene and an olefin other than propylene.

10. The barrier film according to any one of claims 1 to 4, further comprising a barrier coat layer on a side of the vapor deposition film.

11. A laminate comprising the barrier film according to any one of claims 1 to 4 and a heat sealant film.

12. The laminate according to claim 11, further comprising a polypropylene base film.

13. The laminate according to claim 11, comprising a polypropylene base film on a side of the barrier film opposite the heat sealant film,
wherein when a film including the polypropylene base film and a film including the barrier film and the heat sealant film are peeled from each other in accordance with JIS K 6854-2:1999 after retort treatment at 121°C and 0.2 MPa for 30 minutes, a wet peel strength is 0.3 N/15 mm or more.

14. A packaging bag comprising the laminate according to claim 11.

15. The packaging bag according to claim 14, which is a heat-sterilized food pouch.

16. The packaging bag according to claim 15, wherein the laminate includes a polypropylene base film on a side of the barrier film opposite the heat sealant film, and
when a film including the polypropylene base film and a film including the barrier film and the heat sealant film are peeled from each other in accordance with JIS K 6854-2:1999, a wet peel strength is 0.3 N/15 mm or more.
